# EUROPÄISCHE PATENTSCHRIFT

(11) **EP 1 260 017 B1**
(45) Veröffentlichungstag und Bekanntmachung des Hinweises auf die Patenterteilung: **22.09.2004**
(21) Anmeldenummer: 01919159.2
(22) Anmeldetag: 02.03.2001
(51) Int. Cl.: H03F 1/32

(54) **VERFAHREN UND SENDESCHALTUNG ZUR ERZEUGUNG EINES SENDESIGNALS**
METHOD AND TRANSMISSION CIRCUIT FOR PRODUCING A TRANSMISSION SIGNAL
PROCEDE ET CIRCUIT D'EMISSION DESTINES A PRODUIRE UN SIGNAL D'EMISSION

(30) Priorität: 03.03.2000 DE 10010635
(43) Veröffentlichungstag der Anmeldung: 27.11.2002
(73) Patentinhaber: SIEMENS AKTIENGESELLSCHAFT, 80333 München (DE)
(72) Erfinder: BURGER, Klaus, 82515 Wolfratshausen (DE); FUENFGELDER, Helmut, 85386 Dietersheim (DE); MOLIERE, Thomas, 80805 München (DE); WANNENMACHER, Volker, 81369 München (DE); WILHELM, Hartmut, 81477 München (DE); ZSCHUNKE, Willmut, c/o Th Uebert, 64283 Darmstadt (DE)
(86) Internationale Anmeldenummer: PCT/DE2001/000792
(87) Internationale Veröffentlichungsnummer: WO 2001/065682

(56) Entgegenhaltungen:
- WO-A-00/10247
- DE-A- 19 857 542
- GB-A- 2 293 509
- GB-A- 2 301 247
- US-A- 4 511 988
- US-A- 5 404 378
- US-A- 5 574 992

## Beschreibung

Die Erfindung betrifft ein Verfahren zur Erzeugung eines modulierten Sendesignals, bei dem zumindest ein Eingangssignal einer Verstärkerschaltung zugeführt wird, welches in der Verstärkerschaltung verstärkt wird. Der Begriff Verstärkung ist hierbei ganz allgemein, d. h. auch als Verstärkung um einen Faktor kleiner 1 bzw. Dämpfung zu verstehen. Darüber hinaus betrifft die Erfindung eine Sendeschaltung zur Erzeugung eines entsprechenden amplituden- und winkelmodulierten Sendesignals und ein Kommunikationsendgerät mit einer solchen Schaltung.

Insbesondere im Bereich des Mobilfunks ist einer der wesentlichen Gesichtspunkte bei der Entwicklung von Basisstationen und vor allem auch von Mobilfunkgeräten die Optimierung der Sendeschaltung bezüglich der Effizienz und der Linearität der Sendeverstärkung. Zum Ausstrahlen eines Sendesignals wird in diesen Bereichen häufig eine relativ hohe Sendeleistung benötigt. Ein schlechter Wirkungsgrad bei der Verstärkung führt hier zu einer störenden Verlustwärme und, insbesondere bei mobilen Geräten, die batterie- oder akkubetrieben sind, zu einem unbefriedigenden, hohen Stromverbrauch. Ein besonderes Problem hierbei ist, dass einerseits die in der Regel amplituden- und winkelmodulierten Sendesignale häufig einen recht großen Dynamikbereich aufweisen, aber andererseits die Sendeendstufe selbst nur für einen schmalen Regel- bzw. Amplitudenbereich bezüglich des Wirkungsgrads optimiert werden kann. Außerdem muss dafür gesorgt werden, dass das Sendesignal bei der Verstärkung möglichst linear umgesetzt wird und insbesondere in Bezug auf Verzerrungen und Rauschen der Verstärkung ausreichend rein ist.

Um bei einem möglichst großen Wirkungsgrad und möglichst guter Linearität des Sendeverstärkers ein Sendesignal mit hoher Sendeleistung zu erzeugen, ist es dem Fachmann allgemein bekannt, das zu sendende Signal nach Amplitude und Phase zu trennen und am Signaleingang des Sendeverstärkers nur das die Winkelmodulation tragende Signal, d.h. ein winkelmoduliertes Eingangssignal, anzulegen und am Sendeverstärker über (mindestens) einen weiteren Eingang, beispielsweise den Eingang für die Versorgungsspannung oder einen Eingang für die Transistorvorspannung, das Signal, welches die Information über die Amplitudenmodulation enthält (das Amplitudenmodulationssignal) anzulegen. Dabei wird darauf geachtet, dass das winkelmodulierte Eingangssignal und das Amplitudenmodulationssignal zeitlich so zueinander passend angelegt werden, dass die ursprüngliche Signalform wieder entsteht. Bei diesem Verfahren wird also aus dem amplituden- und winkelmodulierten Signal zunächst die Hüllkurve entfernt und im Sendeverstärker wieder hergestellt. Das Verfahren wird daher allgemein auch "Envelope Elimination and Restoration" genannt.

Das Verfahren hat den Vorteil, dass das winkelmodulierte Eingangssignal eine konstante Amplitude aufweist und der Sendeverstärker somit genau auf diese Amplitude wirkungsgradoptimiert werden kann und beispielsweise in Sättigung betrieben werden kann. Das Amplitudenmodulationssignal kann separat geeignet verstärkt werden, so dass insgesamt ein sehr hoher Wirkungsgrad erreicht werden kann. Dies setzt selbstverständlich voraus, dass das Amplitudenmodulationssignal, d.h. die schwankende Versorgungsspannung bzw. Vorspannung des Sendeverstärkers, ihrerseits mit gutem Wirkungsgrad verstärkt bzw. aus einer festen Spannung erzeugt werden kann.

Sofern die Amplitudeninformation und die Winkelinformation getrennt vorliegen, können das winkelmodulierte Eingangssignal und das Amplitudenmodulationssignal auch getrennt erzeugt werden. In diesem Fall ist eine Elimination nicht mehr notwendig, sondern die einzelnen Bestandteile werden separat bearbeitet (z.B. gesteuert oder geregelt) und erst am Sendeverstärker zusammengeführt.

Im Folgenden wird überwiegend von der Verwendung einer solchen Schaltung, bei der der winkelmodulierte und der amplitudenmodulierte Signalanteil im Sendeverstärker auf bekannte Weise zusammengeführt werden, ausgegangen. Dennoch ist die Erfindung nicht auf diese spezielle Art der Signalerzeugung beschränkt. Unter "Winkelmodulation" ist im Übrigen der Oberbegriff für eine Phasen- und Frequenzmodulation zu verstehen. Der Begriff "Winkel" steht dabei stellvertretend für die Größen "Phase" oder "Momentanfrequenz" (zeitliche Ableitung der Phase). Des Weiteren werden die Begriffe "Schaltverstärker", "Class-S-Verstärker", "Schaltmodulator", "Class-S-Modulator" und "DC/DC-Konverter" hier weitestgehend synonym verwendet.

Am Ausgang des Sendeverstärkers muss ein Signal zur Verfügung stehen, welches so rein ist, dass die jeweiligen Vorgaben der für die Geräte verbindlichen Normen erfüllt sind. Im Mobilfunkbereich sind beispielsweise die Kriterien für eine ausreichende Reinheit des Signals eine spektrale Maske, in die die ausgehenden Pulse des Sendesignals passen müssen, sowie die Einhaltung eines normierten Fehlervektors, des EVM, die jeweils durch die Mobilfunkstandards vorgegeben werden. Um diesen Kriterien zu genügen, ist es daher erforderlich, dass Verzerrungen, die eventuell im Sender entstehen könnten, vermieden werden. Ursache von Verzerrungen sind unter anderem Frequenzgänge, die die gewünschten Signale frequenzselektiv dämpfen. Typische Fehlerquellen sind außerdem nichtlineare Charakteristiken des Sendeverstärkers oder anderer Bauteile sowie eine zu geringe Bandbreite einer Phasenregelschleife (Phase Locked Loop; PLL) für den winkelmodulierten - bzw. in diesem Fall phasenmodulierten - Sendesignalanteil. Die auftretenden Verzerrungen hängen zumeist von Randbedingungen wie Betriebsspannung, Temperatur, Sendeleistungspegel und Funkkanalnummer ab und ändern sich während des Betriebs.

Eine Möglichkeit, derartige unerwünschte Verzerrungen zu minimieren, ist eine Linearisierung der Schaltung mit einer Regelschleife. Regelschleifen gibt es in den herkömmlichen Endgeräten innerhalb der Sendeschaltung bereits beispielsweise in Form der bereits genannten PLL oder einer Sendeleistungsregelung, in der auch das Amplitudenmodulationssignal geregelt wird. Je nach Geschwindigkeit der Regelschleife gelingt die Regelung jedoch nicht immer über den gesamten relevanten Frequenzbereich, sondern nur über einen Teil, insbesondere den niederfrequenten Teil. Im restlichen, höheren Frequenzbereich kann nur gesteuert werden. Bei einer solchen Steuerung könnten jedoch Verzerrungen nicht ausgeregelt werden.

Das Dokument GB-A-2 293 509 offenbart eine Funksende-/empfangsschaltung bzw. ein Verfahren zur Signalerzeugung, das derart ausgelegt ist, dass im Sendesignal auftretende Verzerrungen sowie die Abhängigkeit der Verzerrungen von bestimmten Parametern ermittelt werden und in Abhängigkeit von jeweils ermittelten Werten zur Kompensation der Verzerrungen der Verstärkerschaltung jeweils ein entsprechend vorverzerrtes Eingangssignal zugeführt wird. Während des Sendens wird unter Verwendung des eigenen Empfängers der in den Nachbarkanal fallende Anteil der Sendeleistung bestimmt.

Es ist Aufgabe der vorliegenden Erfindung, eine Alternative zu diesem Stand der Technik zu schaffen, mit der auf einfache, kostengünstige und effiziente Weise ein möglichst reines, verzerrungsfreies Sendesignal mit hoher Leistung bei großer Bandbreite und hohem Dynamikumfang erzeugt werden kann.

Diese Aufgabe wird durch die unabhängigen Ansprüche gelöst. Ausgestaltungen der Erfindung sind Gegenstand der Unteransprüche.

Bei einer besonders bevorzugten Ausführungsform wird das Eingangssignal jeweils in einem Digitalteil einer Sendeschaltung berechnet und an einen Analogteil übergeben. Dieser Analogteil enthält die Verstärkerschaltung, die einen geeigneten Sendeverstärker aufweist, und die die Verzerrungen verursacht. Das Sendesignal und gegebenenfalls die besagten Parameter werden dabei in digitalisierter Form im Digitalteil verarbeitet. Außerdem werden im Digitalteil jeweils anhand der aktuell ermittelten Werte der Parameter und/oder der Parameterkombinationen das entsprechend vorverzerrte Signal errechnet und dem Analogteil zugeführt. Das heißt, anstelle eines unveränderten Sendesignals übergibt der Digitalteil an den Analogteil bereits ein entsprechend auf digitaler Ebene verändertes, vorverzerrtes Eingangssignal, um die Verzerrungen im Analogteil zu kompensieren.

Bei einem weiteren bevorzugten Ausführungsbeispiel wird, wie eingangs beschrieben, ein winkelmodulierter Signalanteil und ein Amplitudenmodulationssignalanteil erzeugt und im Sendeverstärker der Verstärkerschaltung zusammengeführt. Dies bietet sich insbesondere dann an, wenn z. B. von einem Digitalteil entsprechende digitale Eingangssignale für den Winkel und die Amplitude dem Analogteil zugeführt werden.

Bei einer Erzeugung des Sendesignals in anderen als polaren Koordinaten, beispielsweise in Inphase- und Quadraturkomponente, können auch diese Größen in Abhängigkeit von jeweils aktuell ermittelten Werten der besagten Parameter und/oder der Parameterkombinationen so vorverzerrt werden, dass die Verzerrungen des Sendesignals kompensiert werden.

Bei den ermittelten Parametern kann es sich beispielsweise um bestimmte Betriebsparameter, wie die Temperatur des Sendeverstärkers, die Eingangs- und/oder Ausgangsleistung für die Amplitude und den Winkel, den Sendeleistungspegel, die Versorgungsspannung, bestimmte Fehlersignale oder den Reflexionsfaktor am Ausgang des Sendeverstärkers handeln. Alle diese Parameter verändern sich permanent während des Sendens und beeinflussen so die Verzerrungen. Da für die verschiedenen Parameter bzw. Parameterkombinationen bekannt ist oder vermessen werden kann, welche Verzerrungen insgesamt in der Schaltung auftreten, ermöglicht die erfindungsgemäße adaptive Vorverzerrung eine rasche Einstellung auf die sich verändernden Bedingungen und somit eine Erzeugung eines nahezu unverzerrten Ausgangssignals.

Die Erfindung hat besondere Vorteile bei Verwendungen in Kommunikationsendgeräten, insbesondere in Mobilfunkgeräten. Sie ist jedoch nicht auf eine solche Anwendung beschränkt.

Bei einem bevorzugten Ausführungsbeispiel werden aus den ermittelten Parametern und/oder Parameterkombinationen sowie den davon abhängigen ermittelten Verzerrungen des Sendesignals Kennlinien (beispielsweise der Schaltung oder von Schaltungsteilen) ermittelt. Die benötigten Vorverzerrungen können dann unter Verwendung dieser Kennlinie berechnet werden. Zur Entzerrung linearer Verzerrungen sollten außerdem auch die Übertragungsfunktionen (der Frequenz und Phasengang) bekannt sein. Es wird daher vorzugsweise auch die Übertragungsfunktion gemessen und die Vorverzerrung unter Verwendung dieser U-bertragungsfunktionen ermittelt.

Die ermittelten Kennlinien, die Übertragungsfunktionen bzw. auch gegebenenfalls direkt die bei bestimmten Parametern oder Parameterkombinationen erforderliche Vorverzerrungen werden vorzugsweise in einem geeigneten Speicher innerhalb des Geräts, welches die Sendeschaltung aufweist, gespeichert. Das heißt, es wird beispielsweise zunächst ein Kennlinienfeld bzw. ein Korrekturwertefeld angelegt, mit Hilfe dessen die Sendeschaltung während des Betriebs aus den aktuellen Parametern und/oder Parameterkombinationen die benötigte Vorverzerrung ermitteln kann.

Diese gespeicherten Informationen, d.h. beispielsweise die Kennlinienfelder, können prinzipiell bereits werkseitig für das jeweilige Gerät vorgegeben sein. Da sich aber die Parameter durch die Umweltbedingungen wie das Alter der Bauteile etc. ändern kann, ist es sinnvoll, wenn das Gerät, welches das Sendesignal erzeugt, selbst in der Lage ist, die Kennlinien, die Übertragungsfunktion bzw. die benötigten Vorverzerrungen zu bestimmen und abzuspeichern. Zur Berechnung der Kennlinien aus den Messwerten der gewünschten Parameter und zur Berechnung der erforderlichen Vorverzerrung aus den Kennlinien können verschiedenste Methoden der Filterung, Interpolation, Fuzzy-Logic und sogar künstliche neuronale Netze eingesetzt werden. Vorzugsweise erfolgt die Verarbeitung der Daten digital, d.h. es werden beispielsweise die im Sendesignal auftretenden Verzerrungen des Sendesignals sowie die Abhängigkeit der Verzerrungen von dem Sollsignal bzw. von den bestimmten Parametern oder Parameterkombinationen im Digitalteil berechnet bzw. ermittelt. In diesen Fällen bietet sich die Verwendung von digitalen Filtern insbesondere mit variablen Koeffizienten an. Eine digitale Signalverarbeitung hat den Vorteil, dass nicht alle Sendedaten durchgetestet werden müssen, sondern dass lediglich eine Auswahl von Testdaten verwendet werden muss und das Ergebnis dieser Testdaten verallgemeinert werden kann, beispielsweise durch geeignete Interpolationsverfahren.

Als Speicher wird vorzugsweise ein wiederbeschreibbarer, nicht flüchtiger Speicher verwendet. Ein solcher Speicher bietet zum Ablegen des Kennlinienfeldes der Übertragungsfunktion bzw. der Vorverzerrungswerte den Vorteil, dass einerseits notwendigen Änderungen der Daten durch eine Aktualisierung jederzeit Rechnung getragen werden kann. Andererseits wird keine elektrische Leistung zum Erhalt der Speicherinhalte benötigt.

Die Ermittlung der Kennlinien, der Übertragungsfunktion bzw. der bei bestimmten Parametern oder Parameterkombinationen erforderlichen Vorverzerrungen werden in einem vorteilhaften Ausführungsbeispiel innerhalb eines Abgleichsmodus durchgeführt. Hierbei werden diese Daten beispielsweise durch Prüfsignale vor dem eigentlichen Sendebetrieb oder in Sendepausen bestimmt. Als Prüfsignal eignen sich zum einen einfache Impulse. Sofern im erheblichen Umfang nichtlineare Verzerrungen auftreten, sind jedoch Wechselprüfsignale, zum Beispiel Sinussignale bei verschiedenen Amplituden und Frequenzen besser geeignet als Impulse. Der Abgleichmodus kann z.B. einmalig ablaufen. Er kann aber auch beliebig zeitgesteuert, d.h. in bestimmten zeitlichen Abständen, durchgeführt werden oder auch bei Änderungen von Betriebsbedingungen bzw. wenn grobe Abweichungen detektiert werden.

Sofern die Möglichkeit zur Linearisierung der Schaltung durch eine Rückkopplung besteht, aber eine solche Rückkopplung möglichst nicht genutzt werden soll, kann der betreffende Schaltungsteil auch für einen Teil der Zeit, beispielsweise im Abgleichmodus, mit Rückkopplung betrieben werden und dabei der Zusammenhang zwischen einem gewünschten Sendesignal und dem dazu erforderlichem vorverzerrten Signal gelernt werden.

Ein Beispiel hierfür besteht darin, dass sowohl ein schneller, breitbandiger Verstärker als auch ein langsamer Schaltverstärker (Class-S-Verstärker) mit einer für eine Regelung an sich zu langen Gruppenlaufzeit zur Versorgung der Endstufe zur Verfügung steht. Es kann dann mit dem schnellen Verstärker und der Regelschleife ermittelt werden, wie der Verlauf der Versorgungsspannung in Abhängigkeit der Sendedaten sein muss, damit sich das gewünschte Sendesignal ergibt. Dabei kann beispielsweise das Signal am Regler oder die Versorgungsspannung der Endstufe abgetastet werden. Das für die Endstufe geeignet vorverzerrte Signal kann dann später entsprechend passend mit dem Class-S-Verstärker erzeugt werden. Sinnvoll ist es auch, bei der Vorverzerrung die Charakteristik des Class-S-Verstärkers selbst bzw. einen Laufzeitausgleich für die Phase entsprechend der unterschiedlichen Gruppenlaufzeiten des schnellen Verstärkers und des Class-S-Verstärkers zu berücksichtigen.

Im Abgleichmodus werden vorzugsweise Maßnahmen getroffen, um unter Wahrung realistischer Betriebsbedingungen für die Endstufe störende Aussendungen des Geräts zu vermeiden. Dies ist beispielsweise durch eine Umschaltung von der Antenne auf eine Abschlusswiderstand mit einer ähnlichen Impedanz und einer ausreichenden Schirmung möglich.

Der Einfluss des impedanzmäßigen Abschlusses, beispielsweise durch die Umschaltung von einer Antenne auf einen Abschlusswiderstand, aber auch durch die veränderliche Anpassung der Antenne aufgrund von unterschiedlichen Abschirmungen der Antenne durch die Handhabung des Benutzers oder andere Umweltbedingungen, auf die Kennlinie des Sendeverstärkers kann dadurch vermindert werden, dass zwischen den Ausgang des Sendeverstärkers und die Antenne ein Element mit Richtwirkung geschaltet wird. Hierfür bietet sich ein Isolator oder ein Zirkulator an. Die Sendeendstufe wird dann weniger durch Reflexionen beeinflusst und lässt sich leichter steuern.

Anstelle oder zusätzlich zur Vermessung mit Prüfsignalen innerhalb eines Abgleichsmodus kann auch das Sendesignal im normalen Betrieb ausgewertet werden. Das heißt, die Ermittlung der Kennlinien und/oder der Übertragungsfunktionen und/oder der zugehörigen Vorverzerrungen erfolgt während des normalen Sendebetriebs. Dies kann beispielsweise dadurch erfolgen, dass zumindest ein Teil des Sendesignals rückgekoppelt wird. Insbesondere kann auch die Übertragungsfunktion während des Sendebetriebs bestimmt werden, indem geeignete Schätzverfahren, wie sie von adaptiven Filtern wie LMS-Filtern oder Kalman-Filtern allgemein bekannt sind, verwendet werden.

Bei einem anderen bevorzugten Ausführungsbeispiel wird zur Ermittlung der Kennlinien, der Übertragungsfunktionen und/oder benötigten Vorverzerrungen zumindest ein Teil des Sendesignals einer Empfangseinrichtung des Geräts einer Analyse zugeführt. Dies ist insbesondere bei solchen Endgeräten vorteilhaft möglich, die nicht gleichzeitig senden und empfangen. Bei diesen Geräten kann der bislang während des Sendens ungenutzte Empfänger in diesen Zeiten zur Analyse des Sendesignals genutzt werden.

Insbesondere bei Systemen bzw. Endgeräten mit einem Frequenzduplex und mit einem vorgegebenen Duplexabstand wird das Sendesignal vom Empfänger nicht ohne weiteres in das Basisband gemischt. Vorteilhafterweise wird daher der Duplexabstand für den Empfänger im Endgerät aufgehoben. Dies ist möglich, indem entweder die Frequenz des Signals entsprechend umgesetzt wird oder der Empfangszweig entsprechend auf den anderen Frequenzbereich umgestimmt wird. Nur_bei sehr schnellen ADCs kann dabei eine Frequenzumsetzung entfallen.

Des Weiteren besteht eine Möglichkeit darin, das Signal auch durch zusätzliche Mischung mit einer Lokaloszillatorfrequenz in Höhe des verbleibenden Duplexabstands vor der Abtastung oder bei ausreichend hoher Abtastfrequenz durch digitale Weiterverarbeitung in die Basisbandlage zu verschieben.

Phasen- und Amplitudenfehler bzw. die Fehlervektorgröße EVM sowie das Spektrum lassen sich im Basisband vergleichsweise leicht berechnen. Je nach gewünschten Kenngrößen bzw. zu ermittelnden Parametern kann aber auch das Signal auf einer anderen Frequenz abgetastet werden, insbesondere dann, wenn Sollgrößen des Sendesignals für die frequenzverschobene Lage bekannt sind. Dies gilt nicht nur für Empfänger, die auf einer Zwischenfrequenz abtasten. Da der Störabstand sehr gut ist, kommt dabei auch eine Unterabtastung ohne aufwendige vorausgehende Bandpassfilterung in Frage.

Bei einem weiteren Ausführungsbeispiel wird die Modulation teilweise oder vollständig entfernt, so dass nur noch der Fehler übrig bleibt. Auch so können die für den Abgleich der Korrekturwerte erforderlichen Informationen gewonnen werden. Wenn das Sendesignal mit einem störenden bekannten Zeitverzug remoduliert wird, dann lässt sich dieser Einfluss auch aus dem digitalen Signal noch herausrechnen. So wird beispielsweise davon ausgegangen, dass das ideale Sendesignal sich durch A(*t*)cos(*j*Φ(*t*)) beschreiben lässt. Wird dieses ideale Sendesignal mit einem weiteren Signal gemäß exp(*j*Φ(*t*+τ₂))/A(*t*+τ₁) gemischt, so ist das Mischprodukt nach einer Tiefpassfilterung in etwa proportional zu exp(*j*(Φ(*t*+τ₂)-Φ(*t*)))·A(*t*)/A(*t*+τ₁). Durch Division durch diesen komplexen Faktor lässt sich folglich der Einfluss der Zeitverzögerung herausrechnen.

Eine geeignete Sendeschaltung muss eine Verstärkerschaltung und Mittel zur Erzeugung zumindest eines Eingangssignals für die Verstärkerschaltung aufweisen. Vorteilhafterweise benötigt diese Schaltung außerdem Mittel zum Erfassen von bestimmten Parametern und/oder Parameterkombinationen und Mittel zur Vorverzerrung des jeweiligen Eingangssignals zur Kompensation von Verzerrungen des Sendesignals. Gegenstand einer Vorverzerrung können dabei beispielsweise der Amplitudengang, Phasengang, die Gruppenlaufzeit und/oder die Korrektur von Nichtlinearitäten sein, wie sie beispielsweise im Verstärker, im gesteuerten Oszillator, bei der Amplitudenmessung, in einem Begrenzer, in den DACs oder ADCs, in DC/DCKonvertern, Mischern oder Phasenkomparatoren auftreten können.

Soweit das Gerät selber die benötigten Vorverzerrungen bei bestimmten Parametern bzw. Parameterkombinationen ermitteln soll, benötigt die Schaltung außerdem Mittel zum Messen der im Sendesignal auftretenden Verzerrungen und entsprechende Mittel zum Ermitteln der Abhängigkeit der Verzerrungen von einem Sollsignal und/oder den Parametern und/oder Parameterkombinationen.

Vorzugsweise weist die Schaltung einen Analogteil, welcher die Verstärkerschaltung enthält, und einen Digitalteil auf, welcher das Eingangssignal berechnet, und das Sendesignal und/oder dessen Fehler beschreibende elektrische Größen und/oder die Parameter in digitalisierter Form verarbeitet, und welcher jeweils anhand des auzusendenden Sollsignals und/oder aktuell ermittelter Werte der Parameter und/oder der Parameterkombinationen das Eingangssignal entsprechend vorverzerrt an den Analogteil übergibt. Durch eine derartige Einrichtung mit digitaler Signalverarbeitung, kann die komplette Berechnung weitgehend auf digitaler Ebene durchgeführt werden.

Eine bevorzugte Ausführungsform einer Sendeschaltung weist außerdem zum einen Mittel zur Erzeugung eines winkelmodulierten Signalanteils und Mittel zur Erzeugung eines Amplitudenmodulationssignals und zum anderen Mittel zum Zusammenführen der beiden Signalanteile in einem Sendeverstärker der Verstärkerschaltung auf.

Sofern die Ermittlung der Kennlinien der Übertragungsfunktion und/oder der Korrekturwerte unter Nutzung des Empfängers bzw. Teilen davon erfolgen soll, muss selbstverständlich der Empfänger dementsprechend eingerichtet sein. Außerdem muss die Sendeschaltung Mittel aufweisen, um von der Antenne einen bestimmten Anteil des Sendesignals in den Empfänger zu leiten. Bei diesem besonders bevorzugten Ausführungsbeispiel "hört" sich das Gerät selbst während des Sendens mit dem eigenen, ansonsten ungenutzten Empfänger zu, so dass jederzeit Parameter einer Vorverzerrung eingestellt und den am Endgerät auftretenden, kaum vermeidbaren Änderungen von Temperaturen, Betriebsspannungen etc. nachgeführt werden können. Eine erfindungsgemäße Vorverzerrung wird damit zu einer realistischen und kostenmäßig attraktiven Alternative zu einer herkömmlichen Regelung. Die Anforderung an die Bandbreiten und Verzögerungen der einzelnen Bauteile wie beispielsweise der Regler, der Schaltmodulatoren oder der Hüllkurvendetektoren werden dabei entscheidend gesenkt, sofern derartige Bauteile überhaupt noch benötigt werden.

Dennoch ist es sinnvoll, auch bei der Möglichkeit der Kompensation über die Vorverzerrung eventuell auftretende Verzerrungen möglichst gering zu halten. Um einer Verzerrung zusätzlich entgegenzuwirken, wird bei einem besonders bevorzugten Ausführungsbeispiel das Amplitudenmodulationssignal unter Verwendung eines Feed-Forward-Verfahrens verstärkt.

Neben einem solchen Feed-Forward-Verfahren kann aber auch die Auswahl geeigneter Verstärker bzw. Verstärkerschaltungen für das Amplitudensignal erheblich dazu beitragen, um bei gleichzeitig großer Effizienz und Bandbreite Verzerrungen zu reduzieren.

Auch kann die Vorverzerrung vorteilhaft mit einer Regelung kombiniert werden. So kann beispielsweise einerseits die Amplitude des Sendesignals geregelt sein, während andererseits die amplitudenabhängige Phasendrehung im Sendeverstärker durch eine Vorverzerrung ausgeglichen wird oder umgekehrt.

Üblicherweise werden zur Verstärkung des Amplitudenmodulationssignals - bei einer Verwendung des eingangs genannten Verfahrens der Aufmodulation der Amplitude auf das winkelmodulierte Eingangssignal innerhalb des Sendeverstärkers - sogenannte "DC/DC-Konverter" verwendet.

Die Verwendung eines DC/DC-Konverters, beispielsweise in Form eines auch Schaltmodulator genannten Schaltverstärkers mit Pulsweitenmodulation zur Verstärkung des niederfrequenten Anteils des Amplitudenmodulationssignals hat den Vorteil, dass hiermit ein besserer Wirkungsgrad erzielt wird als bei einem üblichen Längsregler oder Operationsverstärker. Die Bandbreite eines solchen Schaltverstärkers ist umso größer, je höher die Schaltfrequenz ist, denn hinter den Schaltverstärker wird ein Tiefpass geschaltet, dessen Eckfrequenz so gewählt wird, dass er störenden Anteile im Spektrum der Pulsmodulation wie die Schaltfrequenz und deren Oberschwingungen unterdrückt. Eine hohe Schaltfrequenz führt aber insbesondere durch das Umladen der Gates der im Schaltverstärker verschalteten FETs zu einer beträchtlichen Verlustleistung, und zwar auch dann, wenn nur eine niedrige Spannung erzeugt werden soll und die abgenommene Leistung gering ist. Der Wirkungsgrad des Schaltverstärkers, d.h. das Verhältnis von aufgenommener zu abgegebener elektrischer Leistung, wird unterhalb einer bestimmten abgenommenen Leistung schlechter als die eines Längsreglers oder Operationsverstärkers.

Ein hoher Wirkungsgrad kann bei niedriger abgenommener Leistung mit einer vorteilhaften Ausführung erzielt werden, bei der der DC/DC-Konverter unterschiedlich große Transistoren zum Schalten aufweist und/oder DC/DC-Konverter mit unterschiedlicher Transistorgröße kombiniert werden und/oder je nach Betriebszustand unterschiedlich viele Transistoren aktiv sind. Bei niedriger Ausgangsspannung, wenn nur geringe Lastströme fließen, werden nur kleine Transistoren betrieben, bei denen nur eine niedrige Kapazität umgeladen werden muss. Zwar ist bei diesen Transistoren der Durchlasswiderstand höher, aber bei den niedrigen Strömen sind die dadurch bedingten Verluste geringer als die Verluste, die beim Schalten großer Transistoren anfielen. Bei hoher Last werden weitere Transistoren aktiviert, und/oder es wird mit größeren Transistoren anstelle kleiner Transistoren geschaltet. Dadurch kann dann auch bei einem hohen Laststrom der Spannungsabfall an den Transistoren niedrig gehalten werden.

Ein weiteres Problem besteht darin, dass zwar bei mittlerer und hoher Ausgangsspannung bei einer in der Sättigung betriebenen Sendeendstufe ein annäherungsweise linearer Zusammenhang zwischen der Ausgangsspannung und der Versorgungsspannung der Sendeendstufe erreicht werden kann. In diesem Bereich lässt sich also die Ausgangspannung der Sendeendstufe gut steuern und eine Regelschleife zur Linearisierung ist prinzipiell verzichtbar. Bei nur niedriger Ausgangsspannung ist die Kennlinie jedoch gekrümmt, d.h. es ist eine Linearisierung der Verstärkung der Sendeendstufe durch eine Vorverzerrung oder durch eine Regelschleife notwendig. Für den vorgesehenen Zweck der Modulation des Eingangssignals durch ein auf den Versorgungsspannungseingang oder den Vorspannungseingang geschaltetes Amplitudenmodulationssignal ist zumeist eine ausreichend schnelle und stabile Regelschleife bezüglich des Amplitudenmodulationssignals erforderlich, was wiederum eine große Bandbreite und eine niedrige Gruppenlaufzeit erfordert. Ein Schaltverstärker kann bei einer Regelung die erforderliche Bandbreite in den meisten Fällen nicht erreichen.

Daher ist es besonders vorteilhaft, wenn ein DC/DC-Konverter verwendet wird, der nur in einem Teilbereich der Ausgangsspannung wie ein Schaltverstärker arbeitet. Insbesondere in den Bereichen, in denen ein konventioneller Verstärker oder Längsregler einen besseren Wirkungsgrad bieten würde, schaltet dieser Verstärker nicht mehr, sondern drosselt oder verstärkt ähnlich einem Längsregler oder einem konventionellen Verstärker. Dadurch entfällt die Verlustleistung durch den Takt und das mit ihm erfolgende Umladen. Ein Tiefpassfilter hinter einem solchen Konverter kann entfallen oder in seiner Grenzfrequenz geändert werden, so dass eine größere Bandbreite möglich wird. Wenn der Konverter in dieser nichtschaltenden Betriebsart Teil einer Regelschleife oder Gegenstand einer adaptiven Vorverzerrung ist, dann wird eine eventuelle Nichtlinearität von ihm zusammen mit der Nichtlinearität der Sendeendstufe ausgeregelt bzw. vorentzerrt, so dass je nach Anwendung ein nichtlineares Verhalten in dieser Betriebsart akzeptabel ist.

Ein ähnlicher Zweck wird erreicht, wenn anstelle nur eines Schaltverstärkers eine Verstärkereinheit mit einer Kombination aus einem Schaltverstärker und einem nichtschaltenden, kontinuierlich arbeitenden Verstärker konventioneller Bauart mit höherer Bandbreite verwendet wird. Hierbei gibt es wiederum drei Betriebsmöglichkeiten.

Die eine Möglichkeit besteht darin, dass nur der Schaltverstärker oder nur der konventionelle Verstärker betrieben wird, wobei entsprechend der benötigten Leistung zwischen dem einen und dem anderen Verstärker umgeschaltet wird.

Die zweite Möglichkeit besteht darin, dem Schaltverstärker einen Längsregler nachzuschalten. Insbesondere bei niedriger Last schaltet der DC/DC-Konverter einfach durch oder wird überbrückt, so dass keine Verluste durch das Schalten anfallen. Der nachfolgende Längsregler stellt die gewünschte Ausgangsspannung ein. Um je nach Betriebsart Verluste am Längsregler zu vermeiden, kann auch für ihn eine Überbrückung vorgesehen werden. Diese Anordnung kombiniert die Vorteile von DC/DC-Konverter und Längsregler, nämlich hoher Wirkungsgrad und Geschwindigkeit. Der DC/DC-Konverter folgt im Rahmen seiner Bandbreite der Hüllkurve, beispielsweise ähnlich wie bei "Envelope Tracking", wobei Reserve gelassen wird, damit Amplitudenspitzen nicht durch die Spannung am Ausgang des DC/DC-Konverters begrenzt werden. Der Längsregler unterdrückt störende Anteile im Ausgangssignal des DC/DC-Konverters wie beispielsweise einen Ripple bei der Schaltfrequenz und liefert nötigenfalls auch die höherfrequenten Anteile der Amplitudenmodulation. Dabei ist es zweckmäßig, zumindest die Ausgangsspannung des Längsreglers zu regeln, während der DC/DC-Konverter auch gesteuert betrieben werden kann.

Die dritte Möglichkeit besteht darin, beide Verstärker parallel laufen zu lassen und beispielsweise bei niedrigeren Leistungen nur den Schaltverstärker abzuschalten oder zu überbrücken. Dabei wird das Amplitudenmodulationssignal vorzugsweise in einen niederfrequenten Anteil und einen höherfrequenten oder breitbandigen Anteil aufgespalten und den unterschiedlichen Verstärkern zugeführt. Die Aufteilung ist gegebenenfalls variabel und wird beispielsweise durch entsprechende Filter oder Frequenzweichen bestimmt. Der niederfrequente Anteil besteht beispielsweise aus einem Anteil mit Frequenzen von unter 1 MHz. Dementsprechend deckt der höherfrequente Anteil den oberen Bereich, beispielsweise zwischen 1 MHz und 7 MHz, oder den gesamten Bereich ab. Es kann sich aber bei dem niederfrequenten Anteil auch im Wesentlichen nur um den Gleichspannungsanteil des Amplitudenmodulationssignals handeln.

Die beiden Anteile des Amplitudenmodulationssignals werden dann entweder hinter den Verstärkereinheiten und damit vor dem Eingang des Sendeverstärkers, beispielsweise mittels eines Addierers, zusammengeführt, so dass dann z.B. die Versorgungsspannung oder die Vorspannung des Sendeverstärkers entsprechend über die gesamte Bandbreite mit einem verstärkten Signal moduliert wird. Eine Alternative hierzu ist es, die beiden Anteile des Amplitudenmodulationssignals auf verschiedene Eingänge des Sendeverstärkers zu schalten, beispielsweise den niederfrequenten Anteil quasi als mittlere Versorgungsspannung auf den Versorgungsspannungseingang des Sendeverstärkers zu geben und den höherfrequenten Anteil an die Vorspannung des Sendeverstärkers anzulegen, wodurch ebenfalls insgesamt eine Amplitudenmodulation des Eingangssignals in der gesamten Bandbreite erzeugt wird,

Die Aufteilung in einen niederfrequenten und einen höherfrequenten bzw. breitbandigen Anteil hat hierbei folgende Vorteile: Der niederfrequente Anteil transportiert den größten Teil der benötigten Leistung an den Sendeverstärker. Er kann über hocheffiziente Mittel hergestellt werden, wobei die Anforderung an die Geschwindigkeit gering ist. Das heißt, es kann hierbei der Schaltverstärker mit hohem Wirkungsgrad, aber geringer Bandbreite genutzt werden. Der höherfrequente Anteil, der dagegen eine geringe Leistung transportiert, wird im breitbandigen Verstärker verstärkt, wobei hier wiederum die Anforderungen an den Wirkungsgrad nicht so hoch sind, da bei der benötigten geringen Leistung Verluste nicht so stark ins Gewicht fallen.

Diese Verstärkungsverfahren können auch mit einer Regelung verbunden werden. So kann hierbei der Anteil der niedrigen Frequenzen geregelt werden und der Anteil im oberen Frequenzbereich gesteuert werden. Alternativ ist es aber auch möglich, den niederfrequenten Teil zu steuern und beispielsweise nur den höherfrequenten Teil zu regeln und optional damit auch Fehler, die aufgrund der Steuerung des niederfrequenten Anteils auftreten, auszuregeln. Der Schaltverstärker könnte hierbei sogar einen digitalen Eingang haben und somit digital angesteuert werden. Eine dritte Möglichkeit besteht darin, die Regelung über den gesamten Frequenzbereich durchzuführen, wobei vorzugsweise der kontinuierliche Verstärker die Regelung teilweise oder vollständig übernimmt, da der Schaltverstärker bei einer Regelung der hohen Frequenzen nicht schnell genug ist.

Bei einem bevorzugten Ausführungsbeispiel wird die frequenzmäßige Aufteilung zwischen dem niederfrequenten Anteil, welcher von dem Schaltverstärker verstärkt werden soll, und dem höherfrequenten Anteil, welcher von einem konventionellen Verstärker mit großer Bandbreite verstärkt werden soll, in Abhängigkeit von der gewünschten Ausgangsspannung gewählt, d.h. es findet kein abruptes Umschalten, sondern ein weicher, kontinuierlicher Übergang statt. Insbesondere kann hierbei auch die Schaltfrequenz des Schaltverstärkers variiert werden, vorzugsweise zusammen mit der Eckfrequenz des nachfolgenden Tiefpasses und der Übernahmefrequenz einer vorausgehenden Frequenzweiche.

Ein derartiges Verfahren zur Kombination mindestens zweier Verstärker oder Verstärkermodi, welches einerseits die notwendige Bandbreite gewährleistet und andererseits bei niedriger Ausgangsleistung die durch das Schalten bedingte Verlustleistung des Schaltverstärkers reduziert, ist neben der beschriebenen Verwendung zur Erzeugung eines Amplitudenmodulationssignals mit gutem Wirkungsgrad innerhalb der erfindungsgemäßen Sendeschaltung auch in vielen weiteren Anwendungen sinnvoll. Dieses Verfahren bildet daher einen eigenständigen Erfindungsgedanken.

Der Wirkungsgrad der gesamten Sendeschaltung ist dann besonders attraktiv, wenn auch das Amplitudenmodulationssignal, welches ja die Versorgungsspannung für den Sendeverstärker bildet, seinerseits möglichst verlustarm bereitgestellt werden kann. Die Verwendung eines Schaltverstärkers, der mittels einer Pulsmodulation angesteuert wird, hat den Vorteil, dass am drosselnden Bauelement idealisiert entweder der Strom oder die Spannung und damit auch die Verlustleistung 0 ist. So kann zum Beispiel mit einer Pulsfrequenz- oder Pulsweitenmodulation sowie nachfolgender Tiefpassfilterung mit gutem Wirkungsgrad eine wertkontinuierliche Spannung erzeugt werden.

Wenn sich durch die Vorverzerrung des Sendesignals eine Regelung erübrigt, entfallen die Anforderungen an die Totzeit und entschärfen sich die Anforderungen an die Bandbreite der Baugruppen in den betreffenden Signalpfaden. Je nach Modulationsart und Symbolrate kann dann auch ein Schaltverstärker die für das Amplitudenmodulationssignal erforderliche Bandbreite bereitstellen. Die übliche Realisierung sieht als Schaltverstärker einen entsprechenden Pulsweitenmodulator mit analogem Eingang vor. Gerade in Mobilfunkgeräten werden aber sowohl die Winkelinformationen als auch die Amplitudeninformationen in einem digitalen Signalprozessor DSP erzeugt und liegen somit als digitale Informationen vor. Eine Pulsweitenmodulation mit den herkömmlichen Bauteilen, beispielsweise mittels eines Class-S-Verstärkers gemäß dem Stand der Technik, setzt dann eine D/A-Umsetzung voraus, die einen zusätzlichen Aufwand mit sich bringt und in der Regel nicht ganz linear ist. Das gleiche gilt, wenn beispielsweise ein Regler im Amplitudenzweig digital arbeiten soll, d.h. ein digitaler Vergleich zwischen Soll- und Istwerten durchgeführt werden soll, oder wenn, wie bei der vorliegenden Erfindung, auf digitaler Ebene bereits Vorverzerrungen für die Signale berechnet werden, um Verzerrungen in der weiteren Schaltung zu kompensieren. In allen diesen Fällen besteht die Aufgabe, eine einem digitalen Wert entsprechende Spannung verlustarm bereitzustellen.

Bei einem besonders bevorzugten Ausführungsbeispiel wird daher hierzu ein Pulsmodulator verwendet, der ein pulsmoduliertes Signal direkt aus einem Digitalsignal erzeugt, wobei das pulsmodulierte Ausgangssignal dieses Pulsmodulators durch einen nachgeschalteten Filter geglättet wird, um so ein analoges Amplitudenmodulationssignal bzw. einen Teil davon, vorzugsweise den niederfrequenten Anteil, zu erzeugen. Bei dem pulsmodulierten Signal kann es sich um ein Delta-, Sigma-Delta-, pulsweiten-, pulsfrequenz- oder pulsphasenmoduliertes Signal handeln.

Bei einem besonders bevorzugten Ausführungsbeispiel handelt es sich bei dem pulsmodulierten Signal um ein pulsweiten- oder pulsfrequenzmoduliertes Signal, welches unter Verwendung einer Zählschaltung aus dem Digitalsignal bzw. einem digitalen Wert erzeugt wird.

Ein pulsfrequenzmoduliertes Signal kann hierbei beispielsweise mittels einer von einem Digitalsignal angesteuerten Digitalsyntheseschaltung (DDS) erzeugt werden. Eine solche DDS weist üblicherweise einen Akkumulator, d.h. einen getakteten, rückgekoppelten, speichernden Summierer auf, dessen Zählbereich zyklisch durchlaufen wird. Die Zyklusdauer hängt zum einen von der Taktfrequenz, zum anderen von der Größe eines angelegten Summanden, d.h. dem Addierwert oder sogenannten "Frequenzwort", und dem Zählbereich ab. Dieser Akkumulator addiert mit jedem Takt das Frequenzwort bis zu einem Überlauf und beginnt dann wieder von vorn. Durch die Rückkoppelung des Ausgangs auf den Eingang des Akkumulators wird automatisch der nach einem Überlauf des Akkumulators auftretende Rest beim nächsten Zyklus mit aufaddiert. Es lassen sich folglich in Abhängigkeit von der Taktfrequenz, der Breite des Akkumulators und des Frequenzworts unterschiedliche Ausgangsfrequenzen erzeugen. Mit dieser Methode kann ein moduliertes Signal erzeugt werden, indem während des Betriebs das digitale Frequenzwort entsprechend gewechselt wird. Bei der Pulsfrequenzmodulation mittels der DDS kann einfach das Überlaufsignal oder das Carry-Bit verwendet werden, d.h. es wird ein Puls-Output-DDS-Verfahren benutzt. Diese Zusammenhänge sind allgemein bekannt.

Alternativ zu einem solchen DDS-Verfahren kann auch ein sogenanntes "Fractional-N-Syntheseverfahren" oder ein anderes Frequenzsyntheseverfahren verwendet werden.

Bei einem weiteren bevorzugten Ausführungsbeispiel wird ein pulsweitenmoduliertes Signal unter Verwendung eines von einem Digitalsignal angesteuerten, getakteten Frequenzteilers, beispielsweise einer Flip-Flop-Kette, erzeugt. Durch eine Verknüpfung mehrerer solcher Frequenzteiler mittels logischer Gatter lassen sich unterschiedliche Tastverhältnisse ("Duty-Cycles") erzielen.

Beide Verfahren arbeiten also mit Zählschaltungen. Während bei der Puls-Output-DDS jedoch mit einem die Pulsfrequenz bestimmenden Steuerwort hochgezählt wird, zählt ein Frequenzteiler in Einerschritten.

Die Spannung des gepulsten Signals kann anschließend, beispielsweise unter Verwendung einer Spule, hochtransformiert werden, so dass die Ausgangsspannung größer ist als die Versorgungsspannung des Pulsmodulators.

Je nach Bezugspotential und äußerer Beschaltung kann ein solcher Leistungs-DAC nicht nur positive, sondern auch negative Spannungen abgeben. Sofern eine Masse, eine negative und eine positive Versorgungsspannung zur Verfügung stehen, können beispielsweise jeweils derartige DC/DC-Konverter zwischen die positive Versorgungsspannung und die Masse sowie die negative Versorgungsspannung und die Masse geschaltet werden. Vorteilhaft ist hier, soweit der Ausgangsspannungsbereich der DC/DC-Konverter nicht betragsmäßig nach unten begrenzt ist, jeweils nur einen der beiden DC/DC-Konverter einzuschalten und dadurch die Verlustleistung durch den jeweils anderen DC/DC-Konverter zu vermeiden. Auf diese Weise lassen sich sowohl positive als auch negative Spannungen mit gutem Wirkungsgrad erzeugen. Hierbei ist es außerdem vorteilhaft, Baugruppen wie die Takterzeugung sowie den Tiefpass am Ausgang oder Teile derselben für beide DC/DC-Konverter gemeinsam zu nutzen, so dass im Wesentlichen noch die Schalter getrennt wären. Sofern dies zur Vergrößerung des Frequenzbereichs erforderlich ist, bietet sich auch die Kombination mit einem Operationsverstärker an.

Insbesondere bei Geräten, die mittels mehrerer in Reihe geschalteter Zellen, beispielsweise Batterien, mit Energie versorgt werden, lässt sich durch eine geeignete Anzapfung sowohl eine positive als auch eine negative Versorgungsspannung gewinnen. Der Ruhestrom ist dann dabei niedrig, denn für Ausgangspannungen gleich 0 wäre das Tastverhältnis des Schaltverstärkers 0, so dass keine Leistung für Schaltvorgänge aufgewendet werden bräuchte. Neben mobilen Endgeräten eignet sich eine solche Schaltung folglich auch beispielsweise für Audioendstufen mit digitaler Ansteuerung, beispielsweise Aktivboxen, die in Anlehnung an dieses Konzept entworfen werden könnten.

Die Anwendung einer solchen Form der D/A-Umsetzung bzw. digital gesteuerten DC/DC-Konvertierung ist nicht auf die Erzeugung der Versorgungsspannung für eine Sendeverstärkereinheit bzw. eines Amplitudenmodulationssignals beschränkt. Ein solcher Schaltmodulator kann auch allgemein als Leistungs-DAC mit hohem Wirkungsgrad eingesetzt werden. Er bildet daher ebenfalls eine eigenständige Erfindungsidee auch außerhalb des Rahmens der vorliegenden Erfindung.

Insofern lehrt die vorliegende Erfindung also auch allgemein ein Verfahren zur Verstärkung, bei dem unter Einsatz von Pulsmodulationen aus einer elektrischen Versorgungsspannung eine variable Ausgangsspannung erzeugt wird, wobei die Höhe der Ausgangsspannung bei gegebener Versorgungsspannung durch ein Digitalsignal eingestellt wird.

Für die vorliegende Erfindung bietet dieser Erfindungsgedanke insbesondere den Vorteil, dass eine digitale und damit aufwandsgünstige sowie sehr lineare Steuerung möglich ist, wobei beispielsweise im Messzweig für die Amplitude ein ADC eingesetzt wird. Dies ist zur Ermittlung dieses Wertes, der als Parameter zur Durchführung des erfindungsgemäßen Verfahrens zur Vorverzerrung der Signale benötigt wird, ohnehin erforderlich.

Insbesondere in Fällen, in denen eine durch die endliche Rechengeschwindigkeit eventuell entstehende Totzeit tolerierbar ist, können mit einem solchen digital gesteuerten Schaltmodulator erreichte Vorteile der digitalen Signalverarbeitung auch bei Regelungen genutzt werden. Es kann dann das digitale Ist-Signal direkt mit dem digitalen Soll-Signal verglichen werden, und auf digitaler Ebene kann ein Abgleich erfolgen. In Abhängigkeit vom berechneten Regelfehler kann dann direkt der Pulsmodulator mit dem digitalen Eingang angesteuert werden.

Die Erfindung wird im Folgenden unter Hinweis auf die beigefügten Zeichnungen anhand von Ausführungsbeispielen näher erläutert. In den Figuren werden in den verschiedenen Ausführungsbeispielen verwendete gleichartige Bauteile zur besseren Übersichtlichkeit teilweise mit denselben Bezugsziffern bezeichnet. Es stellen dar:
Figur 1 ein schematisches Blockschaltbild eines ersten Ausführungsbeispiels einer erfindungsgemäßen Sendeschaltung,
Figur 2 ein schematisches Blockschaltild eines zweiten Ausführungsbeispiels einer erfindungsgemäßen Sendeschaltung,
Figur 3 ein schematisches Blockschaltbild einer Regelung eines Amplitudenmodulationssignals mittels eines Feed-Forward-Verfahrens,
Figur 4 ein schematisches Blockschaltbild einer Regelung eines Amplitudenmodulationssignals gemäß einem dritten Ausführungsbeispiel der Erfindung,
Figur 5 ein schematisches Blockschaltbild einer Schaltung zur Erzeugung eines Amplitudenmodulationssignals mittels eines Leistungspulsmodulators mit digitaler Ansteuerung,
Figur 6 ein schematisches Blockschaltbild einer Verstärkereinrichtung zur Verstärkung des Amplitudenmodulationssignals.

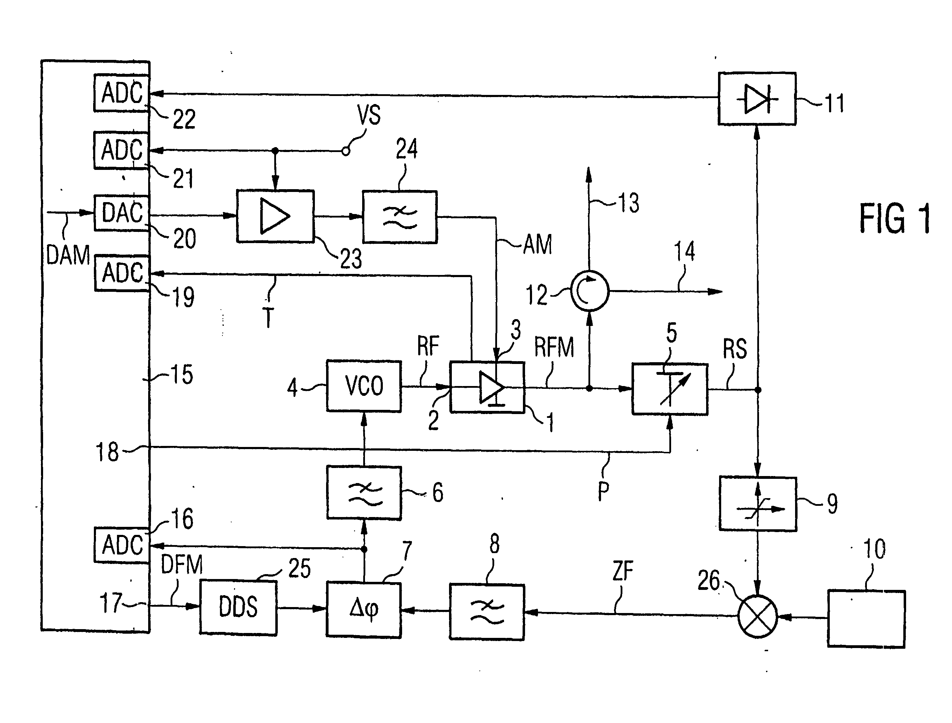

Die erfindungsgemäße Sendeschaltung gemäß dem Ausführungsbeispiel nach Figur 1 weist ein Digitalteil 15 auf. Hierbei kann es sich beispielsweise um einen üblichen digitalen Signalprozessor (DSP) handeln, wie er auch in anderen Geräten, insbesondere Mobilfunkgeräten, verwendet wird. Gegebenenfalls weist dieser DSP auch zusätzliche Ein- und Ausgänge mit integrierten ADCs oder DACs auf, um zusätzliche Parameter empfangen oder ausgeben zu können, und er ist entsprechend zur Durchführung des erfindungsgemäßen Verfahrens in geeigneter Weise programmiert. Der Digitalteil ist lediglich der Einfachheit halber in Form eines einzelnen Blocks 15 dargestellt. Er kann auch aus mehreren geeignet zusammengeschalteten Komponenten bestehen. In diesem Digitalteil 15 werden z.B. mit den herkömmlichen, im Mobilfunk verwendeten Verfahren die jeweils benötigten Informationen über die Amplitude und den Winkel bzw. die Phase des jeweiligen Sendesignals berechnet. Diese Informationen werden dann innerhalb des Analogteils der Schaltung entsprechend den vorgegebenen digitalen Werten erzeugt und zu einem amplituden- und winkelmodulierten Sendesignal zusammengesetzt.

Bei dem in der Figur 1 dargestellten Ausführungsbeispiel wird die Winkelinformation in Form eines digitalen Frequenzinformationssignals DFM, hier eines digitalen Frequenzworts, am Ausgang 17 zunächst einer digitalen Syntheseschaltung 25 zur Verfügung gestellt. Hierbei handelt es sich um eine Puls-Output-DDS 25. Anstelle einer Puls-Output-DDS könnten auch andere Schaltungen zur Erzeugung eines zwischenfrequenten Signals, das die Information über die Sollphase enthält, eingesetzt werden, beispielsweise mit Quadraturamplitudenmodulator mit Inphase- und Quadraturkomponente oder mit Fractional-N-Teiler. Die ausgehenden Pulse dieser DDS 25 werden dann in eine Phasenregelschleife, in vorliegenden Fall eine Offset-PLL, geleitet, die im Wesentlichen aus einem Phasenkomparator 7, einem Schleifenfilter 6, einem VCO 4 und einem Lokaloszillator 10 sowie einem Mischer 26 besteht. Dieser Lokaloszillator 10 kann auch gleichzeitig als Oszillator für die DDS 25 dienen (nicht dargestellt). Weitere Komponenten, die sich innerhalb dieses Phasenregelkreises befinden, sind der Sendeverstärker 1, ein Abschwächer 5 sowie ein Begrenzer 9 und ein weiterer Tiefpass 8.

Das eigentliche phasenmodulierte Signal RF wird hierbei von dem VCO erzeugt. Dieser VCO oszilliert in einer Frequenz abhängig von einer gegebenen Eingangsspannung, welche wiederum durch das Ausgangssignal der DDS 25 beeinflusst wird. Das phasenmodulierte Ausgangssignal RF des VCO 4 wird auf den Signaleingang 2 des Sendeverstärkers 1 gegeben, der in Sättigung betrieben wird, um so einen maximalen Wirkungsgrad und eine möglichst große Linearität zu erreichen.

Die im Digitalteil in Form eines digitalen Amplituden-Ansteuersignals DAM zur Verfügung stehende Information über die jeweilige aktuelle Amplitude wird über ein DAC 20 als analoges Signal ausgegeben und in einem Verstärker 23, hier ein Class-S-Schaltverstärker, verstärkt. Das Ausgangssignal des Verstärkers 23 wird durch einen Tiefpass 24 geleitet, um wieder ein geglättetes, analoges Signal AM zu erhalten. Das hierbei erzeugte Amplitudenmodulationssignal AM wird auf den Versorgungsspannungseingang 3 des Sendeverstärkers 1 gegeben, wodurch das Amplitudenmodulationssignal AM auf das phasenmodulierte Signal RF aufmoduliert wird und am Ausgang des Sendeverstärkers 1 das gewünschte amplituden- und winkelmodulierte Sendesignal RFM entsteht.

Das Sendesignal RFM wird dann über einen Zirkulator 12 einer Antenne 13 zugeführt. Das dritte Tor 14 des Zirkulators 12 ist mit einem Empfängereingang reflexionsarm abgeschlossen. Reflexionen und Empfangssignale von der Antenne beeinträchtigen daher die Sendeverstärkereinheit nicht. Ein Abgleich und eine Vorverzerrung werden folglich durch derartige eventuellen Reflexionen weniger gestört. Das gleiche gilt auch für den Rückkopplungszweig des Sendesignals RFM, welcher ebenfalls weniger durch die Reflexionen der Antenne beeinflusst werden kann. Die Beeinflussung der Rückkopplung durch etwaige Reflexionen lässt sich beispielsweise auch durch einen Isolator vor der Antenne oder durch einen Richtkoppler zur Auskopplung des Rückkopplungssignals weitgehend vermeiden.

Dieser Rückkopplungszweig läuft zunächst über den Abschwächer 5, welcher über einen Ausgang 18 des digitalen Teils 15 mit einem Pegelsignal P gesteuert werden kann, um so das Sendesignal entsprechend dem eingestellten Sendeleistungspegel abzuschwächen.

Bei vielen Anwendungen lässt sich die Sendeleistung der erforderlichen Reichweite anpassen. Beim Mobilfunkstandard GSM gibt es dafür beispielsweise den sogenannten "Power-Control-Level". Weiterhin wird zur Vermeidung von Nachbarkanalstörungen, welche durch einen burstweisen Betrieb hervorgerufen werden, die Sendeleistung zum Burstbeginn langsam von 0 auf den Zielwert gebracht und am Burstende langsam heruntergefahren. Dieses Verfahren ist als sogenanntes "Power-Ramping" bekannt. Das Power-Ramping und der "Power-Control-Level" sind Beispiele für den hier verwendeten Ausdruck "Sendeleistungspegel". Der Begriff ist aber nicht darauf beschränkt und soll eine wertkontinuierliche Leistungseinstellung einschließen.

Das am Ausgang des Abschwächers 5 anliegende Signal wird dann aufgetrennt und einerseits über einen Hüllkurvendetektor 11, der die aktuelle Amplitude misst, in einen ADC 22 des digitalen Teils 15 geleitet. Das reine Amplitudensignal steht dort für die Berechnung der Vorverzerrung und, soweit zusätzlich zur Vorverzerrung geregelt wird, auch zur Regelung der Amplitudenmodulation als Ist-Signal zur Verfügung. Andererseits wird das hinter dem Abschwächer 5 anliegende Signal einem Begrenzer 9 zugeführt, welcher die Amplitudenmodulation unterdrückt und nur den phasenmodulierten Anteil des Signals durchlässt. Das Ausgangssignal am Begrenzer 9 wird dann in einem Mischer 26 unter Verwendung des Lokaloszillators 10 auf eine Zwischenfrequenz ZF entsprechend der Ausgangsfrequenz der DDS 25 heruntergemischt und durch einen Tiefpassfilter 8 geleitet. Dieses zwischenfrequente Ausgangssignal ZF entspricht dabei einem Istsignal für die Regelung des phasenmodulierten Anteils RF. Es wird in einen Phasenkomparator 7 geleitet und dort mit dem Ausgangssignal der DDS 25 verglichen. Die Differenz entspricht dabei der Abweichung des phasenmodulierten Istsignals von dem durch die DDS 25 vorgegebenen Sollsignal.

Das Differenzsignal wird über einen weiteren Tiefpass 6, den sogenannten Schleifenfilter 6, geglättet und so in einen analogen Spannungswert verwandelt, welcher entsprechend dem Differenzsignal wiederum den VCO 4 ansteuert, wodurch die Phasenregelschleife geschlossen ist.

Das vom Phasenkomparator 7 ausgehende Differenzsignal, welches dem Phasenfehler entspricht, wird außerdem über einen ADC-Eingang 16 dem digitalen Teil zugeleitet und steht dort als ein Parameter für die Berechnung der Vorverzerrung zur Verfügung. Als weitere Messwerte werden über einen ADC 19 die Temperatur T des Sendeverstärkers 1 gemessen und über einen weiteren ADC 21 die Versorgungsspannung VS des Schaltverstärkers 23, welche beispielsweise von einem Akkupack entnommen wird.

Im Digitalteil 15 werden die besagten Messwerte für Amplitude, Temperatur, Phasenfehler und Versorgungsspannung mit dem eingestellten Sendeleistungspegel und den aktuellen Abtastwerten für Amplitude und Winkel bzw. Phase verknüpft. In einem Abgleichmodus wird dabei ein Kennlinienfeld berechnet und gespeichert. Auch die Übertragungsfunktion wird gemessen und gespeichert. Aus diesen Daten werden dann mit den jeweils auszugebenden idealen Abtastwerten für Amplitude und Winkel entsprechend vorverzerrte Abtastwerte berechnet, die eine Verzerrung innerhalb der gesamten Schaltung kompensieren. Die vorverzerrten Abtastwerte werden dann wie dargestellt mittels der DDS in ein winkelmoduliertes Teilsignal und mittels des D/A-Konverters und der nachfolgenden Verstärkungsschaltung 23, 24 in eine Amplitudensteuerung umgesetzt. Das Ergebnis wird über den Phasenfehler und den Amplitudenmesswert mit Hilfe der beiden ADCs 16, 22 beobachtet. Auch die übrigen Parameter wie die Versorgungsspannung VS und die Temperatur T werden über die ADCs 21, 19 laufend kontrolliert. Auf diese Weise kann zusätzlich geregelt und/oder können Kennlinien nachgeführt werden. Bei groben Fehlern kann außerdem ein erneuter Abgleichmodus aufgerufen werden, um aktuellere Kennlinien oder eine neue Übertragungsfunktion zu berechnen und abzuspeichern.

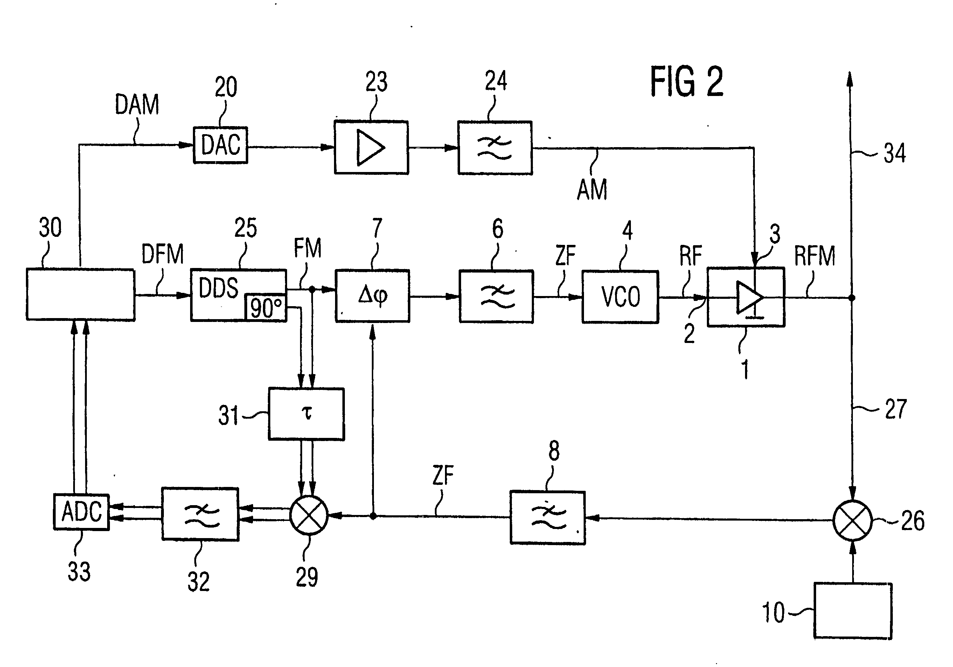

Figur 2 zeigt einen etwas anderen Aufbau einer erfindungsgemäßen Sendeschaltung. Hierbei wird von einer digitalen Basisband-Signalverarbeitung (DBB), dargestellt als ein Digitalteil 30, das Sendesignal in Form eines digitalen Amplituden-Ansteuersignals DAM und eines Frequenzinformationssignals DFM ausgegeben.

Aus der digitalen Frequenzinformation DFM erzeugt eine DSS 25 eine zwischenfrequente Schwingung FM, die den Phasenmodulationsanteil des gewünschten Sendesignals enthält. Das phasenmodulierte Signal wird mit einer Offset-PLL, welche einen Sendeverstärker 1 umschließt, auf die Trägerfrequenz RF verschoben. Diese Offset-PLL besteht wiederum im Wesentlichen aus einem Phasenkomparator 7, einem Schleifenfilter 6, einem VCO 4 sowie einem Mischer 26 und dem Lokaloszillator 10. Aus dem digitalen Amplitudenansteuersignal wird in einem DAC 20 ein analoges Signal erzeugt, welches in einem Verstärker 23, vorzugsweise einem Schaltverstärker 23 mit nachfolgendem Tiefpassfilter 24, verstärkt und dann auf den Versorgungsspannungseingang 3 des Sendeverstärkers 1 gegeben wird, so dass im Sendeverstärker 1 das Amplitudenmodulationssignal AM auf das winkelmodulierte Signal RF aufmoduliert wird. Wie bereits dargestellt könnte ein Schaltverstärker 23 vorteilhaft mit einem DAC 20 zu einem Leistungs-DAC zusammengefasst werden.

Am Ausgang des Sendeverstärkers 1 liegt dann wieder das gewünschte amplituden- und phasenmodulierte Signal RFM an, welches zum einen über den Anschluss 34 zu einer Antenne geleitet wird. Die Verbindung zur Antenne erfolgt vorzugsweise wieder über einen Zirkulator oder Isolator (nicht dargestellt). Zum anderen wird das Sendesignal RFM über die Rückführung 27 zur Bildung der Phasenregelschleife dem Phasenkomparator 7 zugeführt. Hierzu wird das Signal mittels des Lokaloszillators 10 und des Mischers 26 auf die Zwischenfrequenz ZF, welche durch die DDS 25 vorgegeben wird, heruntergemischt. Das Signal wird dann erneut durch einen Tiefpassfilter 8 geleitet und schließlich dem Phasenkomparator 7 zugeleitet.

Sofern der Mischer 26 der Offset-PLL linear arbeitet, d.h. in diesem Mischer keine AM/AM- und AM/PM-Konversion auftritt, gibt der Fehler dieses zwischenfrequenten Signals ZF sowohl die Amplituden- als auch die Phasenfehler des Sendesignals RFM wieder. Mit einem zweiten Mischer 29, der ebenfalls linear arbeiten muss, und einem spektral ausreichend reinen Signal der DDS 25, bei der es sich hier vorzugsweise nicht um eine Puls-Output-DDS handelt, wird die Frequenz der DDS 25 wieder herausgerechnet. Eine Zeitverschiebung zwischen dem rückgeführten Signal und dem Signal der DDS kann durch ein Verzögerungsglied 31 kompensiert werden. In diesem Mischer 26 wird nicht nur das DDS-Signal an sich, sondern auch noch einmal das DDS-Signal um 90 Grad phasenverschoben zur Verfügung gestellt. Hierzu weist die DDS 25 zwei Ausgänge auf, wobei aus einem Ausgang direkt die Ausgangsschwingung entnommen wird und aus dem anderen Ausgang das um 90 Grad verschobene Signal. Beide Signale werden parallel durch das Verzögerungsglied 31 geleitet und dem Mischer 26 zugeführt. Der Mischer 26 ist in der Lage, mittels des DDS-Signals und des um 90 Grad phasenverschobenen DDS-Signals das rückgeführte Signal in eine Inphase- und eine Quadraturkomponente herunterzumischen. Übrig bleibt dann ein komplexwertiges Signal, dessen Amplitude der Sendeamplitude und dessen Phase der Phasendrehung der Schaltung, im Idealfall einer Konstanten, entspricht. Dieses Signal ist im allgemeinen breitbandiger als das Sendesignal im Basisband, denn für die reine Amplitudenmodulation ergibt sich bei den betrachteten Modulationsarten eine größere Bandbreite als für das ursprüngliche Signal im Basisband, und die Amplitude ist nicht mit der zu der Modulation gehörigen Phase, sondern mit dem Phasenfehler kombiniert. Dennoch kann aus dem so gewonnenen Signal im komplexen Basisband die benötigte Information für den Parameterabgleich gewonnen werden. Dabei kann auch - sofern vorhanden - eine eventuelle Dezimation, d.h. eine Reduktion der Abtastrate, im nachfolgenden ADC 33 geringer dimensioniert werden, damit die Abtastwerte mit einer höheren Rate zur Verfügung stehen und ein sogenanntes "Aliasing" vermindert wird. Die Tiefpassfilter 8 und 32 unterdrücken unerwünschte Mischprodukte.

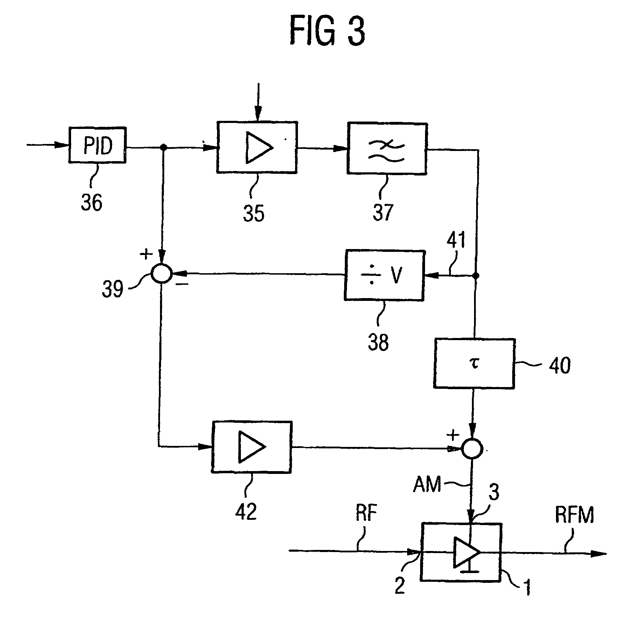

Figur 3 zeigt einen Ausschnitt aus einer Sendeschaltung mit einem speziellen Konzept zur Verstärkung des Amplitudenmodulationssignals unter Verwendung eines Feed-Forward-Verfahrens, um Verzerrungen zu minimieren.

Das Eingangssignal geht hierbei zunächst auf einen optionalen Regler 36, hier vorzugsweise einen PID-Regler 36. Bei einer reinen Steuerung kann der Regler entfallen. Das Ausgangssignal dieses PID-Reglers 36 wird geteilt, wobei ein Teil durch einen DC/DC-Konverter 35, hier einen Schaltkonverter 35, geleitet und dort verstärkt wird. Ein nachfolgender Tiefpassfilter 37 glättet das Signal und eliminiert die störenden Schaltfrequenzen des Verstärkers 35. Der Tiefpass 37 ist optional. Das so verstärkte Signal wird zum einen über die Abzweigung 41 einem Teiler 38 zugeführt, welcher das Signal durch die Verstärkung teilt und an ein Subtraktionsglied 39 weiterleitet. Außerdem wird das vom Regler 36 kommende Originalsignal dem Subtraktionsglied 39 zugeführt. Die Differenz der beiden Signale wird von einem weiteren Verstärker 42, welcher eine besonders hohe Eckfrequenz hat, verstärkt und zu dem um seine Gruppenlaufzeit in einem Verzögerungsglied 40 zeitverzögerten Ausgang des DC/DC-Konverters 35 bzw. des Tiefpasses 37 addiert. Somit wird ein im DC/DC-Konverter erzeugter "Fehler" durch das über den Verstärker 42 erzeugte Differenzsignal wieder kompensiert. Die Verstärkung der Verstärker 35 und 42 ist gleich.

Wenn nur eine geringe Spannung an dem Sendeverstärker angelegt werden soll, d.h. bei kleinen Amplituden, leidet der Wirkungsgrad des DC/DC-Konverters 35. Der Verstärker 42 ist in diesem Betriebsfall in der Lage, den gesamten Strom für die Endstufe allein zu liefern. Wenn der Gesamtwirkungsgrad dadurch steigt, wird daher sinnvollerweise der DC/DC-Konverter 35 abgeschaltet.

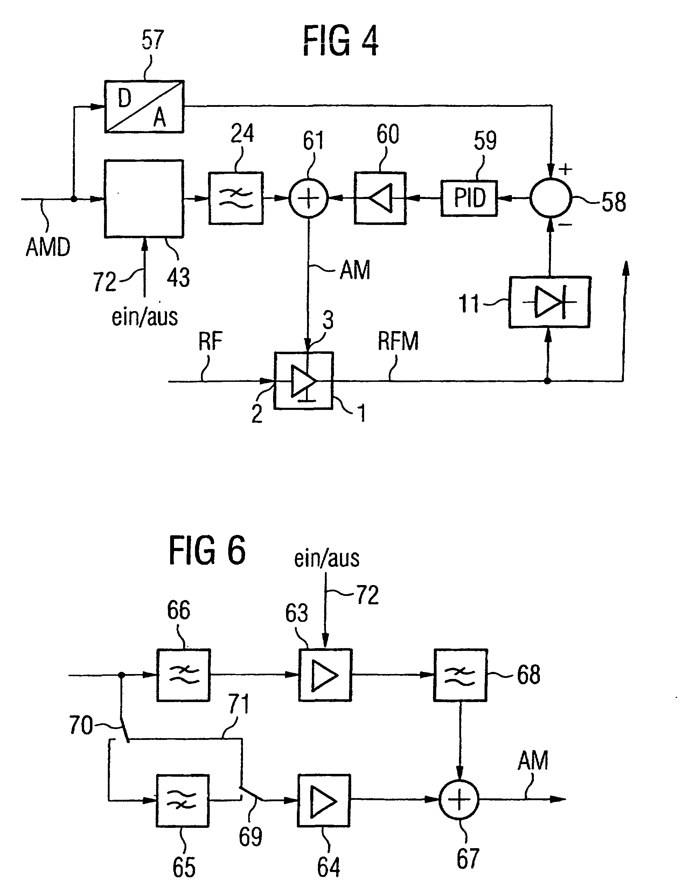

Ein anderes Ausführungsbeispiel zur Optimierung des Amplitudenmodulationssignals ist in Figur 4 gezeigt. Hierbei wird ein digitaler Sollwert für die Hüllkurve, d.h. ein digitales Amplitudenmodulationssignal AMD vorgegeben. Dies ist gerade für die vorliegende Erfindung besonders vorteilhaft, da hier ja möglichst weitgehend auf digitaler Ebene gearbeitet werden soll. Dieses digitale Amplitudenmodulationssignal wird mittels eines Pulsweitenmodulators 43 in einen analogen Wert umgesetzt. Ein solcher Pulsweitenmodulator 43 weist einen im Mittel guten Wirkungsgrad auf. Das Ausgangssignal dieses Pulsweitenmodulators 43 wird durch einen Tiefpass 24 von störenden Frequenzanteilen, wie sie etwa durch die Schaltfrequenz bedingt sind, befreit. Wegen des Tiefpasses 24 erreicht der Pulsweitenmodulator 43 nicht die benötigte Bandbreite. Daher wird das digitale Amplitudenmodulationssignal AMD abgezweigt und auf einen DAC 57 gegeben. Hierbei handelt es sich um einen Standard-DAC 57 mit niedriger Ausgangsleistung. In ihm ist ein Tiefpass mit sehr hoher Eckfrequenz als Rekonstruktionsfilter eingebaut, so dass keine Treppenstufen, sondern ein geglättetes Signal ausgegeben wird. Die Bandbreite des Standard-DACs 57 ist ausreichend gewählt, so dass das Amplitudenmodulationssignal an dieser Stelle möglichst ohne Verzerrungen übermittelt wird. Das Ausgangssignal dieses zum Pulsweitenmodulator 43 parallel geschalteten DACs 57 ist das Soll-Signal, welches in eine Regelschleife mündet. Das Soll-Signal wird mit einem mittels eines Hüllkurvendetektors 11 über den Rückkopplungszweig ermittelten Ist-Signal der Amplitude verglichen. Hierzu dient ein Subtraktionsglied 58. Das Differenzsignal, welches dem Fehler in der Sendeamplitude entspricht, wird mit einem Regler 59, vorzugsweise einem PID-Regler, welcher proportional, integrierend und differenzierend wirkt, bewertet und mit einem Verstärker 60 mit kleiner Leistung verstärkt. Dieser Verstärker 60 verursacht lediglich eine geringe Verlustleistung, seine Leistung genügt bei großer Sendeamplitude nur, um Fehler auszuregeln und hohe Frequenzen zu ergänzen, während der Hauptanteil der Leistung vom Pulsweitenmodulator 43 kommt.

Bei sehr niedriger Sendeamplitude kann dieser kleine Verstärker 60 den Sendeverstärker 1 dagegen allein versorgen. Der Pulsweitenmodulator 43 wird dann abgeschaltet. Damit entfällt auch die Verlustleistung, die zum hochfrequenten Schalten der Versorgungsspannung nötig ist, beispielsweise für das Umladen von Gate-Kapazitäten von FETs im Pulsmodulator 43. Die Koeffizienten des PID-Reglers 59 werden dann vorzugsweise der neuen Übertragungsfunktion des Regelkreises angepasst.

Insbesondere dann, wenn der Tiefpassfilter 24 hinter dem Pulsweitenmodulator 43 eine einstellbare Bandbreite hat und die Koeffizienten des PID-Reglers 59 ausreichend nachgeführt werden können, kann auch die Schaltfrequenz des Pulsweitenmodulators 43 der Sendeamplitude oder deren zeitlichen Mittelwert, beispielsweise gegeben durch den Sendeleistungspegel, angepasst werden. Auf diese Weise wird der Pulsweitenmodulator 43 nicht hart zu- und weggeschaltet, sondern die frequenzmäßige Aufteilung verschiebt sich je nach Ausgangsleistung. Bei geringer Ausgangsleistung ist die Schaltfrequenz gering, damit möglichst wenig Verlustleistung durch das Schalten erzeugt wird. Bei großer Ausgangsleistung fällt dagegen eine größere Verlustleistung durch eine hohe Schaltfrequenz kaum ins Gewicht. Die Schaltfrequenz und die Grenzfrequenz der nachfolgenden Filterung im Tiefpass 24 werden so hoch gewählt, dass der Verstärker 60 mit der geringen Leistung nicht durch die Anteile in den höheren Frequenzen überfordert wird und dass sich ein guter Gesamtwirkungsgrad ergibt. Wenn möglich werden auch die Koeffizienten des PID-Reglers 59 entsprechend an die Eckfrequenz des Tiefpasses 24 angepasst. Ein solcher Übergang kann nicht nur kontinuierlich, sondern auch in Stufen erfolgen, wobei als Kriterium nicht nur die momentane Sendeamplitude, sondern beispielsweise auch ein eingestellter Sendeleistungspegel oder ein Kurzzeitmittelwert in Frage kommen.

Der Gleichspannungsanteil und die niedrigen Frequenzen, bei denen die größte Leistungsdichte liegt, werden dadurch über einen weiten Bereich vom Pulsmodulator 43 mit einem angemessenen Wirkungsgrad bereitgestellt. Die digitalen Ansteuersignale für den Pulsweitenmodulator 43 und den Standard-DAC 57 können auch unterschiedlich sein. So können sie beispielsweise unterschiedlich skaliert sein, einen unterschiedlichen Frequenzgang aufweisen, mit einem differentiellen Zeitversatz versehen werden oder unterschiedlich nichtlinear vorverzerrt werden, um so beispielsweise Nichtlinearitäten in den verschiedenen Strecken oder in der Kennlinie des Sendeverstärkers 1 auszugleichen.

Anstelle des Pulsweitenmodulators 43 kann auch ein anderer Pulsmodulator, beispielsweise ein Pulsfrequenzmodulator, gewählt werden. Ebenso kann hier auch eine andere digital ansteuerbare Spannungsquelle, beispielsweise eine Kombination aus mehreren DC/DC-Konvertern oder entsprechend anzapfbare Batterien bzw. Akkumulatoren mit mehreren Zellen verwendet werden.

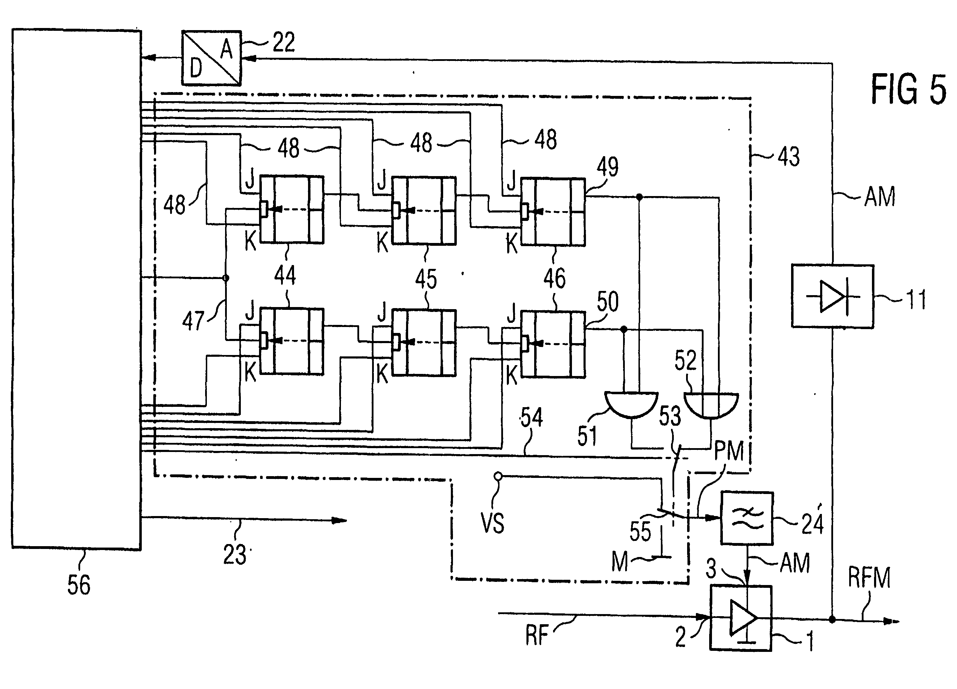

Figur 5 zeigt einen schematischen Schaltplan für ein konkreteres Ausführungsbeispiel eines geeigneten Pulsweitenmodulators 43. Hierbei ist der Pulsweitenmodulator 43 durch zwei Frequenzteiler aufgebaut, die aus jeweils drei zu Ketten zusammengeschalteten JK-Flip-Flops 44, 45, 46 bestehen. Bei diesen Frequenzteilern handelt es sich um Zählschaltungen, wobei das jeweils vorderste Flip-Flop 44, an dem die Taktleitung 46 anliegt, als LSB (Least Significant Bit) fungiert und das in der Kette letzte Flip-Flop 46 bzw. dessen Ausgang 49, 50 das MSB (Most Significant Bit) der Zählschaltung angibt. Werden die MSB an den Ausgängen 49, 50 von zwei parallel betriebenen, gleich langen Frequenzteilerketten miteinander logisch verknüpft, lässt sich die Pulsbreite des Ausgangssignals durch den Unterschied der Initialisierungswerte der Zähler einstellen. Für Duty-Cycles > 0,5 können die beiden Ausgänge 49, 50 logisch mittels eines Oder-Gatters 52 verknüpft werden, kleinere Duty-Cycles lassen sich mit einem Und-Gatter 51 erzielen. Die Pulsbreite lässt sich sowohl symmetrisch als auch unsymmetrisch vergrößern, je nachdem, ob beide Zählerinhalte oder nur ein Zählerinhalt verändert wird.

Im vorliegenden Fall werden zum Erzeugen eines pulsweitenmodulierten Signals die Flip-Flops 44, 45, 46 zuerst über die Leitungen 48 und die Eingänge J und K von einer Logik, in diesem Beispiel vom DSP 56, mit einem passenden Offset initialisiert und der Schalter 28 von dem DSP 56 entsprechend auf das Und-Gatter 51 oder das Oder-Gatter 52 geschaltet. Dann wird jeweils über die Leitungen 48 eine 1 an den J- und K-Eingängen angelegt, so dass die Ketten bei anliegendem Takt über die Leitung 47 am Takteingang des jeweils ersten Flip-Flops 44 als Frequenzteiler arbeiten. In dem vorliegenden Beispiel kann mit den drei Flip-Flops 44, 45, 46 in jeder der Ketten eine Auflösung von 3 Bit erzielt werden. Das vom Und-Gatter 51 oder vom Oder-Gatter 52 abgegriffene Signal steuert wiederum einen beispielsweise mit einem FET aufgebauten Schalter 55, der im Rhythmus des pulsweitenmodulierten Signals eine Versorgungsspannung VS, welche an dem einen Eingang des Schalters 55 anliegt, auf einen Tiefpassfilter 24 weiterleitet. Dieser Tiefpassfilter 24 glättet die Spannung und erzeugt so die gewünschte analoge Spannung bzw. das amplitudenmodulierte Signal AM, welches den Sendeverstärker 1 versorgt.

Optional kann der Eingang des Tiefpasses 24 auf eine Masse M geschaltet werden, wenn er nicht mit der Spannungsversorgung VS verbunden ist. In diesem Fall ist die Impedanz am Eingang des Tiefpassfilters 24 stets niedrig. Wenn der Eingang des Tiefpassfilters 24 stattdessen offen gelassen würde, geht zwar unter Umständen weniger Leistung verloren, aber der Zusammenhang zwischen Pulsweite und analoger Ausgangsspannung ist im allgemeinen lastabhängig und nicht mehr proportional. Dadurch wäre dann ein Einsatz einer Tabelle im Digitalteil notwendig, um einen dadurch entstehenden Fehler auszugleichen. Eine alternative Lösung anstelle einer Schaltung auf Masse könnte je nach Tiefpassschaltung darin bestehen, eine Diode vom Eingang des Tiefpasses so gepolt mit der Masse fest zu verbinden, dass sie bei einem auf die Spannungsversorgung geschalteten Schalter sperrt.

Eine Pulsweitenmodulation ist im Prinzip auch mit einer einzigen Flip-Flop-Kette möglich. Dieses Ausführungsbeispiel ist nicht dargestellt. In diesem Fall müsste dann ein digitaler Vergleicher verwendet werden, der ober- oder unterhalb eines bestimmten Zählerinhalts ein Flag setzt oder löscht. Wenn der Vergleicher nicht "größer" oder "kleiner", sondern nur Gleichheit von zwei Signalen erkennt, kann mit ihm ein Flip-Flop gesetzt werden, das in Abhängigkeit eines bestimmten Zählerstands oder einer bestimmten Zählerstelle, insbesondere des MSBs, wieder gelöscht wird. Der Flip-Flop-Ausgang lässt sich so in Abhängigkeit des Vergleichswerts pulsweitenmodulieren.

Eine Messung des Amplitudenmodulationssignals AM erfolgt dadurch, dass ähnlich wie in Figur 1 über einen Rückkopplungszweig und einen Hüllkurvendetektor 11 die aktuelle Amplitude zurückübermittelt wird. In dem in Figur 5 dargestellten Ausführungsbeispiel wird das analoge aktuelle Amplitudensignal einem ADC 22 zugeführt und in einen digitalen Wert umgesetzt. Dieses digitale Signal wird dem DSP 56 zugeführt. Der gemessene Wert wird zur Kontrolle und/oder Berechnung der Vorverzerrungs-Korrekturwerte und optional auch zur Regelung genutzt. In dem DSP 56 findet wie in den anderen Ausführungsbeispielen die digitale Basisband-Signalverarbeitung statt, d.h. der DSP stellt auch die digitalen Steuersignale über die Leitungen 48 für die Zählerketten des Pulsmodulators 43 zur Verfügung. Es ist dann eine vollkommen digitale Signalverarbeitung möglich, wobei wenn nötig der digitale Sollwert auch, wie in dem Ausführungsbeispiel gemäß Figur 4, über einen DAC umgewandelt werden kann und zu einer schnellen Korrektur durch Vergleich mit einem abgezweigten analogen, aktuellen Amplitudensignal genutzt werden kann.

Im DSP 56 wird bei einer Änderung der Pulsweite im laufenden Betrieb ein günstiger Zeitpunkt ausgewählt, um über die Leitungen 48 zu den Eingängen J und K der Flip-Flops den Wert zumindest eines Teils der Flip-Flops gezielt zu verändern.

Da in dem vorliegenden Ausführungsbeispiel der DSP 56 die komplette Basisband-Signalverarbeitung durchführt, liegt hier im Übrigen auch der Wert für die aktuelle Winkelmodulation an. Dieses digitale Winkelmodulationssignal FM wird über die Leitung 23 auf eine geeignete Schaltung, beispielsweise eine DDS mit nachfolgender Offset-PLL, geleitet (nicht dargestellt). Diese erzeugt aus dem digitalen Winkelmodulationssignal FM ein geeignetes Winkelmodulationssignal RF mit konstanter Amplitude, welches wiederum auf den Eingang 2 des Sendeverstärkers 1 gegeben wird. Neben der Auskopplung über den Rückkopplungszweig und den Hüllkurvendetektor 11 des amplitudenmodulierten Anteils des amplituden- und winkelmodulierten Sendesignals RFM zur Messung des Amplitudenmodulationssignals kann auch, beispielsweise über einen Begrenzer, der winkelmodulierte Anteil des Sendesignals RFM gewonnen werden und zu Regelungszwecken und zur Berechnung der Vorverzerrungs-Korrekturwerte zurückgeführt werden (nicht dargestellt).

Bei dem DSP 56 handelt es sich beispielsweise wieder um den üblicherweise in derartigen Sendeschaltungen vorhandenen DSP, der entsprechend zur Ausgabe der digitalen Signale modifiziert wurde.

Figur 6 zeigt noch einmal einen Ausschnitt aus einem weiteren Ausführungsbeispiel zur Verstärkung eines Amplitudenmodulationssignals AM. Bei diesem Ausführungsbeispiel wird das Eingangssignal auf einer Strecke durch einen Tiefpass 66, anschließend durch einen ein-/ausschaltbaren Class-S-Verstärker 63 und durch einen nachgeschalteten weiteren Tiefpass 68 zu einem Addierer 67 geleitet. Ein anderer Teil des Signals wird über zwei Schalter 70, 69 und je nach Schalterstellung der beiden Schalter 70, 69 über einen Hochpass 65 oder über eine Überbrückungsleitung 71 zu einem Breitbandverstärker 64 mit niedriger Leistung geleitet, dessen Ausgang wiederum ebenfalls auf den Addierer 67 geht. Am Ausgang des Addierers 67 liegt dann das verstärkte Amplitudenmodulationssignal AM an.

Wenn eine hohe Ausgangsleistung des Amplitudenmodulationssignals AM gefordert ist, fällt der durch das Schalten bedingte Sockel im Leistungsverbrauch des Class-S-Verstärkers 63 kaum ins Gewicht. Bei einer hohen Ausgangsleistung, d.h. bei hoher momentaner Amplitude, ist daher der Class-S-Verstärker 63 eingeschaltet und die Schalter 70, 69 befinden sich in der nicht dargestellten Stellung. In diesem Zustand wird durch den Tiefpass 66 sowie den Hochpass 65, die als Frequenzweiche fungieren, das ankommende Signal in einen niederfrequenten Anteil (inklusive Gleichspannungsanteil) und in einen höherfrequenten Anteil aufgespalten. Der niederfrequente Anteil wird von dem Class-S-Verstärker 63 verstärkt. Die höherfrequenten Anteile, von denen anzunehmen ist, dass sie nur wenig Leistung enthalten, werden von dem breitbandigen Verstärker 64 mit dem nur bescheidenen Wirkungsgrad verstärkt. Die Verlustleistung ist dabei jedoch - absolut gesehen - nur mäßig groß, weil dieser Breitbandverstärker 64 ja nur die geringen Leistungen verstärken muss. Durch den Einsatz des Class-S-Verstärkers 63 wird das Gesamtsignal mit gutem Wirkungsgrad auch bei hohen Leistungen verstärkt. Der Tiefpass 68 am Ausgang des Class-S-Verstärkers 63 sorgt wiederum für die Unterdrückung der insbesondere durch das Schalten erzeugten Störfrequenzen. Durch das Addieren im Addierer 67 ergibt sich insgesamt ein ausreichend linearer Frequenzgang.

Wenn nur eine geringe Amplitude, d.h. eine niedrige Ausgangsleistung gewünscht wird, würde jedoch der Verlustleistungssockel des Class-S-Verstärkers 63 zu einem insgesamt sehr schlechten Wirkungsgrad führen. In diesem Fall wird der Class-S-Verstärker 63 über den Eingang 72 ausgeschaltet, und der Hochpass 65 vor dem Breitbandverstärker 64 wird durch die Schalter 70, 69 und die Brückenleitung 71 überbrückt. Der Breitbandverstärker 64 übernimmt dann das schwache Signal in seiner vollen Bandbreite.

Alternativ kann auch ein weicherer Übergang erzeugt werden, indem der Class-S-Verstärker 63 nicht abgeschaltet wird, sondern stattdessen seine Schaltfrequenz sowie die Bandbreite des nachfolgenden Tiefpasses 68 abgesenkt wird und gleichzeitig die Eckfrequenzen des Hochpasses 65 und des Tiefpasses 66 an den Eingängen der beiden Verstärker 63, 64 verringert werden.

Bei einem weiteren, nicht dargestellten Ausführungsbeispiel werden die Frequenzweichen digital realisiert. Hierzu werden zwischen die Frequenzweiche und die Verstärker DACs geschaltet oder die Verstärker werden als DACs mit entsprechender Leistung ausgeführt. Ebenso ist es möglich, in dem Zweig für den überwiegend höherfrequenten Anteil einen Verstärker mit analogem Eingang und einen vorgeschalteten DAC zu verwenden und im anderen Zweig für den niederfrequenten Anteil (bzw. Gleichspannungsanteil) einen DAC mit entsprechend hoher Ausgangsleistung einzusetzen.

Liste der verwendeten Abkürzungen:
- ADC: Analog/Digital-Konverter
- AM: Amplitudenmodulation
- DC: Direct Current (Gleichstrom)
- DDS: Direct Digital Synthesis (Digitalsyntheseschaltung)
- DSP: Digitaler Signalprozessor
- DAC: Digital/Analog-Konverter
- EER: Envelope Elimination and Restoration
- EVM: Error Vector Magnitude
- FET: Feldeffekttransistor
- LSB: Least Significant Bit
- MSB: Most Significant Bit
- PID: proportional, integrierend und differenzierend wirkender Regler
- PM: Phasenmodulation
- VCO: Voltage Controlled Oscillator (Spannungsgesteuerter Oszillator)

### Bezugszeichenliste

- ***1***: ***Sendeverstärker***
- ***2***: ***Signaleingang***
- ***3***: ***Versorgungsspannungseingang***
- ***4***: ***VCO***
- 5: Abschwächer
- 6: Schleifenfilter
- 7: Phasenkomparator
- 8: Tiefpass
- 9: Begrenzer
- 10: Lokaloszillator
- 11: Hüllkurvendetektor
- 12: Zirkulator
- 13: Antenne
- 14: Tor
- 15: Digitalteil
- 16: ADC
- 17: Ausgang
- 18: Ausgang
- 19: ADC
- 20: DAC
- 21: ADC
- 22: ADC
- 23: Verstärkungsschaltung
- 24: Tiefpassfilter
- 25: digitale Syntheseschaltung/DDS
- 26: Mischer
- 28: Schalter
- 27: Rückführung
- 29: Mischer
- 30: Block
- 31: Verzögerungsglied
- 32: Tiefpassfilter
- 33: ADC
- 34: Antennenanschluss
- 35: DC/DC-Konverter
- 36: PID-Regler
- 37: Tiefpassfilter
- 38: Teiler
- 39: Subtraktionsglied
- 40: Verzögerungsglied
- 41: Abzweigung
- 42: Verstärker
- 43: Pulsweitenmodulator
- 44: JK-Flip-Flop
- 45: JK-Flip-Flop
- 46: JK-Flip-Flop
- 47: Leitung
- 48: Leitung
- 49: Ausgang
- 50: Ausgang
- 51: Und-Gatter
- 52: Oder-Gatter
- 55: Schalter
- 56: DSP
- 57: DAC
- 58: Subtraktionsglied
- 59: PID-Regler
- 60: Verstärker
- 63: Verstärker
- 64: Breitbandverstärker
- 65: Hochpass
- 66: Tiefpass
- 67: Mischer
- 68: Tiefpass
- 69: Schalter
- 70: Schalter
- 71: Überbrückungsleitung
- 72: Eingang
- M: Masse
- P: Pegelsignal
- AM: Amplitudenmodulationssignal
- RF: winkelmoduliertes Signal
- FM: digitales Winkelmodulationssignal
- ZF: Zwischenfrequenz
- VS: Versorgungsspannung
- RFM: winkel- und phasenmoduliertes Sendesignal
- AMD: digitales Amplitudenmodulationssignal
- DAM: digitales Amplituden-Ansteuersignal
- DFM: digitales Frequenzinformationssignal

## Patentansprüche

1. Verfahren zur Erzeugung eines modulierten Sendesignals (RFM) in einem Kommunikationsendgerät, das derart ausgelegt ist, nicht zur selben Zeit Signale zu senden und zu empfangen, wobei das Kommunikationsendgerät eine Empfangseinrichtung und eine Sendeschaltung aufweist,
wobei in der Sendeschaltung zumindest ein Eingangssignal (DAM, DFM) einer Verstärkerschaltung zugeführt wird, welches in der Verstärkerschaltung verstärkt wird, um das Sendesignal zu erzeugen,
wobei im Sendesignal (RFM) aufgrund der Verstärkerschaltung auftretende Verzerrungen sowie die Abhängigkeit der Verzerrungen von einem Sollsignal ermittelt werden;
wobei in Zeiten, in denen das Sendesignal erzeugt wird, ein vorbestimmter Teil des Sendesignals der Empfangseinrichtung zur Analyse zugeführt wird,
**dadurch gekennzeichnet, dass**
der zur Analyse bestimmte Anteil des Sendesignals in der Empfangseinrichtung ins Basisband umgesetzt wird, um dort die aufgrund der Verstärkerschaltung auftretenden Verzerrungen des Sendesignals (RFM) zu berechnen, in Abhängigkeit von denen das zumindest eine Eingangssignal (DAM, DFM) vorverzerrt und der Verstärkerschaltung zugeführt wird.

2. Verfahren nach Anspruch 1, **dadurch gekennzeichnet, dass** die Vorverzerrung ferner auf der Basis von ermittelten gerätespezifischen Parametern (VS, T) und/oder Parameterkombinationen berechnet wird.

3. Verfahren nach Anspruch 2, **dadurch gekennzeichnet, dass** das Eingangssignal (DAM, DFM) jeweils in einem Digitalteil (15, 30) der Sendeschaltung berechnet wird und an einen die Verstärkerschaltung mit einem Sendeverstärker (1) aufweisenden, verzerrenden Analogteil der Sendeschaltung übergeben wird, und das Sendesignal (RFM) und die Parameter (VS,T) unter Verwendung der Empfangseinrichtung digitalisiert und im Digitalteil verarbeitet werden, und dass im Digitalteil (15, 30) jeweils anhand der aktuell ermittelten Werte der Parameter (VS, T) und/oder der Parameterkombinationen das entsprechend vorverzerrte Signal (DAM, DFM) errechnet und dem Analogteil zugeführt wird.

4. Verfahren nach Anspruch 2 oder 3, **dadurch gekennzeichnet, dass** ein winkelmodulierter Signalanteil (RF) und ein Amplitudenmodulationssignal (AM) erzeugt und in einem Sendeverstärker (1) der Verstärkerschaltung zusammengeführt werden.

5. Verfahren nach einem der Ansprüche 2 bis 4, **dadurch gekennzeichnet, dass** aus den ermittelten Parametern (VS, T) und/oder Parameterkombinationen und den davon abhängigen, ermittelten Verzerrungen des Sendesignals Kennlinien ermittelt werden und eine notwendige Vorverzerrung unter Verwendung dieser Kennlinien ermittelt wird.

6. Verfahren nach einem der Ansprüche 2 bis 5, **dadurch gekennzeichnet, dass** eine Übertragungsfunktion ermittelt wird und eine notwendige Vorverzerrung unter Verwendung dieser Übertragungsfunktion ermittelt wird.

7. Verfahren nach Anspruch 5 oder 6, **dadurch gekennzeichnet, dass** die ermittelten Kennlinien und/oder die Übertragungsfunktion gespeichert werden.

8. Verfahren nach einem der Ansprüche 5 bis 7, **dadurch gekennzeichnet, dass** die Kennlinien und/oder die Übertragungsfunktion von einem das Eingangssignal erzeugenden Schaltungsteil der Sendeschaltung selbst ermittelt werden.

9. Verfahren nach Anspruch 8, **dadurch gekennzeichnet, dass** die Ermittlung der Kennlinien und/oder der Übertragungsfunktion innerhalb eines Abgleichmodus erfolgt.

10. Verfahren nach Anspruch 8 oder 9, **dadurch gekennzeichnet, dass** die Ermittlung der Kennlinien und/oder der Übertragungsfunktion während des normalen Sendebetriebs erfolgt.

11. Verfahren nach einem der Ansprüche 8 bis 10, **dadurch gekennzeichnet, dass** zur Ermittlung der Kennlinien und/oder der Übertragungsfunktion zumindest ein Teil (RS) des Sendesignals (RFM) auf den das Eingangssignal erzeugenden Schaltungsteil der Sendeschaltung rückgekoppelt wird.

12. Verfahren nach Anspruch 4, **dadurch gekennzeichnet, dass** das Amplitudenmodulationssignal (AM) mittels eines Verstärkers eingestellt wird, der in Abhängigkeit von der Ausgangsleistung in verschiedenen Betriebsarten betrieben wird, wobei eine erste Betriebsart eine Schaltverstärkung umfasst und eine zweite Betriebsart eine kontinuierliche Verstärkung umfasst, oder welcher unterschiedlich große Transistoren aufweist, die je nach Betriebsart in unterschiedlichen Kombinationen aktiv oder inaktiv sind, oder dass das Amplitudenmodulationssignal (AM) mittels einer Verstärkereinheit (62) eingestellt wird, welche eine Kombination eines Schaltverstärkers (63) und eines kontinuierlichen, breitbandigen Verstärkers (64) und/oder Reglers umfasst.

13. Verfahren nach Anspruch 12, **dadurch gekennzeichnet, dass** das Amplitudenmodulationssignal (AM) in einen niederfrequenten Anteil und einen höherfrequenten Anteil aufgeteilt bearbeitet wird.

14. Verfahren nach Anspruch 13, **dadurch gekennzeichnet, dass** der Schaltverstärker (35, 43, 63) für den niederfrequenten Anteil des Amplitudenmodulationssignals (AM) bei einer nur geringen benötigten Gesamtleistung des Amplitudenmodulationssignals (AM) abgeschaltet und/oder überbrückt wird.

15. Verfahren nach einem der Ansprüche 4 bis 14, **dadurch gekennzeichnet, dass** das Amplitudenmodulationssignal (AM) unter Verwendung einer Kombination von Schaltverstärkung und Feed-Forward-Verfahren verstärkt wird.

16. Verfahren nach einem der Ansprüche 4 bis 15, **dadurch gekennzeichnet, dass** das Amplitudenmodulationssignal (AM) unter Verwendung eines pulsmodulierten Signals (PM) aus einer Versorgungsspannung erzeugt wird, wobei das pulsmodulierte Signal (PM) aus einem Digitalsignal erzeugt wird.

17. Verfahren nach Anspruch 16, **dadurch gekennzeichnet, dass** das pulsmodulierte Signal (PM) ein pulsweitenund/oder pulsfrequenzmoduliertes Signal (PM) umfasst, welches unter Verwendung einer Zählschaltung (44 bis 50) aus dem Digitalsignal erzeugt wird.

18. Verfahren nach Anspruch 17, **dadurch gekennzeichnet, dass** das pulsfrequenzmodulierte Signal mittels einer von einem Digitalsignal angesteuerten Digitalsynthese-Schaltung erzeugt wird.

19. Verfahren nach Anspruch 17, **dadurch gekennzeichnet, dass** das pulsweitenmodulierte Signal (PM) unter Verwendung eines von einem Digitalsignal angesteuerten, getakteten Frequenzteilers (44 bis 50) erzeugt wird.

20. Verfahren nach Anspruch 19, **dadurch gekennzeichnet, dass** die Ausgangssignale mehrerer Frequenzteiler (44 bis 50) logisch untereinander zu einem pulsweitenmodulierten Signal verknüpft werden.

21. Kommunikationsendgerät, das dafür ausgelegt ist, nicht zur selben Zeit Signale zu senden und zu empfangen, wobei das Kommunikationsendgerät folgende Merkmale aufweist:
eine Sendeschaltung zur Erzeugung eines modulierten Sendesignals (RFM), wobei die Sendeschaltung Mittel (15) zur Erzeugung zumindest eines Eingangssignals (DAM, DFM) umfasst, das einer Verstärkerschaltung zugeführt wird, wobei das Eingangssignal (DAM, DFM) durch die Verstärkerschaltung verstärkt wird, um das Sendesignal zu erzeugen,
eine Empfangseinrichtung, die zu Zeiten, in denen das Sendesignal erzeugt wird, einen Teil des eigenen Sendesignals empfängt, um das Sendesignal bezüglich Verzerrungen, die durch die Verstärkerschaltung verursacht werden, zu analysieren,
Mittel zur Einkopplung zumindest eines Teils des Sendesignals (RFM) in die Empfangseinrichtung zur Analyse des Sendesignals,
**dadurch gekennzeichnet, dass**
die Empfangseinrichtung Mittel zur Umsetzung des von der Empfangseinrichtung empfangenen zur Analyse bestimmten Anteils des Sendesignals (RFM) ins Basisband umfasst, um dort die aufgrund der Verstärkerschaltung auftretenden Verzerrungen des Sendesignals (RFM) zu berechnen ,
wobei die Sendeschaltung ferner Mittel zur Vorverzerrung des jeweiligen Eingangssignals (DAM, DFM) in Abhängigkeit von den berechneten Verzerrungen des Sendesignals und zum Zuführen des vorverzerrten Eingangssignals (DAM, DFM) zur Verstärkerschaltung umfasst.

22. Kommunikationsendgerät nach Anspruch 21, **gekennzeichnet durch** Mittel zum Erfassen von gerätespezifischen Parametern (VS, T) und/oder Parameterkombinationen, auf deren Basis die Vorverzerrung ferner berechnet wird.

23. Kommunikationsendgerät nach Anspruch 22,
**gekennzeichnet durch**
Mittel zum Messen von im Sendesignal (RFM) aufgrund der Verstärkerschaltung auftretenden Verzerrungen,
Mittel zum Ermitteln der Abhängigkeit der Verzerrungen von einem Sollsignal und den Parametern (VS, T) bzw. Parameterkombinationen.

24. Kommunikationsendgerät nach Anspruch 22,
**gekennzeichnet durch**
einen Analogteil, welcher die Verstärkerschaltung mit einem Sendeverstärker (1) aufweist,
einen Digitalteil (15, 30), welcher das Eingangssignal (DAM, DFM) berechnet, und das Sendesignal (RFM) und/oder dessen Fehler beschreibende elektrische Größen und/oder die Parameter (VS,T) in digitalisierter Form verarbeitet,
und welcher jeweils anhand des auzusendenden Sollsignals und/oder aktuell ermittelter Werte der Parameter (VS, T) und/oder der Parameterkombinationen das Eingangssignal (DAM, DFM) entsprechend vorverzerrt an den Analogteil übergibt.

25. Kommunikationsendgerät nach einem der Ansprüche 22 bis 24, **gekennzeichnet durch** Mittel zur Erzeugung eines winkelmoduliertes Signalanteils (RF), Mittel zur Erzeugung eines Amplitudenmodulationssignals (AM) und Mittel zur Zusammenführung des winkelmodulierten Signalanteils (RF) und des Amplitudenmodulationssignals (AM) in einem Sendeverstärker (1) der Verstärkerschaltung.

26. Kommunikationsendgerät nach einem der Ansprüche 22 bis 25, **gekennzeichnet durch** Mittel zur Ermittlung von Kennlinien und/oder Übertragungsfunktionen.

27. Kommunikationsendgerät nach einem der Ansprüche 22 bis 26, **gekennzeichnet durch** einen Speicher zum Speichern der bei bestimmten Parametern und/oder Parameterkombinationen erforderlichen Vorverzerrungen und/oder der Kennlinien und/oder der Übertragungsfunktionen.

28. Kommunikationsendgerät nach einem der Ansprüche 22 bis 27, **gekennzeichnet durch** richtungsselektive Mittel (12) zwischen einem Ausgang des Sendeverstärkers (1) und einer Antenne.

29. Kommunikationsendgerät nach Anspruch 25, **gekennzeichnet durch** Mittel zur getrennten Bearbeitung eines niederfrequenten Anteils und eines höherfrequenten Anteils des Amplitudenmodulationssignals (AM).

30. Kommunikationsendgerät nach einem der Ansprüche 22 bis 29, **gekennzeichnet durch** einen Schaltverstärker der verschiedene Betriebsarten aufweist, wobei eine erste Betriebsart eine Schaltverstärkung umfasst und eine zweite Betriebsart eine kontinuierliche Verstärkung umfasst, oder welcher unterschiedlich große Transistoren aufweist, die je nach Betriebsart in unterschiedlicher Kombination aktiv oder inaktiv sind, oder eine Verstärkereinheit (62), welche eine Kombination eines Schaltverstärkers (63) und eines kontinuierlichen, breitbandigen Verstärkers (64) und/oder Reglers umfasst.

31. Kommunikationsendgerät nach einem der Ansprüche 22 bis 30, **gekennzeichnet durch** Schaltmittel (69, 70, 72) zum Überbrücken und/oder Abschalten von Bauteilen (63, 65) und/oder Bauteilkombinationen innerhalb von Regel- oder Steuerstrecken.

32. Kommunikationsendgerät nach Anspruch 25, **gekennzeichnet durch** einen Rückkopplungspfad (41) mit einem Teiler (38) zur Durchführung einer Feed-Forward-Korrektur bei einer Verstärkung des Amplitudenmodulationssignals (AM).

33. Kommunikationsendgerät nach einem der Ansprüche 22 bis 32; **gekennzeichnet durch** einen Pulsmodulator (43) zur Erzeugung eines pulsmodulierten Signals (PM) aus einem Digitalsignal sowie einen nachgeschalteten Filter (24) zur Erzeugung eines analogen Amplitudenmodulationssignals (AM).

34. Kommunikationsendgerät nach Anspruch 33, **dadurch gekennzeichnet, dass** der Pulsmodulator (PM) eine Zählschaltung (44 bis 50) zur Erzeugung eines pulsweiten- oder pulsfrequenzmodulierten Signals (PM) umfasst.

35. Kommunikationsendgerät nach Anspruch 34, **dadurch gekennzeichnet, dass** der Pulsmodulator eine Digitalsynthese-Schaltung zur Erzeugung eines pulsfrequenzmodulierten Signals umfasst.

36. Kommunikationsendgerät nach Anspruch 34, **dadurch gekennzeichnet, dass** der Pulsmodulator (43) einen von einem Digitalsignal angesteuerten, getakteten Frequenzteiler (44 bis 50) zur Erzeugung eines pulsweitenmodulierten Signals (PM) umfasst.

37. Kommunikationsendgerät nach Anspruch 36, **dadurch gekennzeichnet, dass** der Pulsmodulator (43) mehrere Frequenzteiler (44 bis 50) umfasst, die mittels Logikgattern (51, 52) untereinander verbunden sind.

38. Kommunikationsendgerät nach einem der Ansprüche 22 bis 37, **gekennzeichnet durch** A/D-Wandler (16, 22, 33) in Rückkopplungszweigen für die aktuellen Werte der Amplitude und/oder des Winkels des Sendesignals und/oder eines davon abgeleiteten Signals und Mittel zur Durchführung eines digitalen Vergleichs von Ist- und Sollwerten für die Amplitude und/oder des Winkels und/oder einer davon abgeleiteten Größe.

## Claims

1. Method for generating a modulated send signal (RFM) in a communication terminal which is designed so as not to send and receive signals at the same time, in which case the communication terminal features a receiver station and a send circuit,
in which case at least one input signal (DAM, DFM) of an amplifier circuit is fed into the send circuit of an amplifier circuit which is amplified in the amplifier circuit to generate the send signal,
in which case in the send signal (RFM) as a result of the amplifier circuit distortions which occur as well as the dependence of the distortions on a required signal is determined;
in which case at times in which the send signal is generated, a prespecified part of the send signal is fed to the receiver device for analysis,
**characterized in that** the component of the send signal intended for analysis is converted in the receiver device into the baseband in order to calculate the distortions of the send signal (RFM) occurring there as a result of the amplifier circuit, depending on which the at least one input signal (DAM, DFM) is pre-distorted and fed to the amplifier circuit.

2. Method in accordance with Claim 1, **characterized in that** the pre-distortion is further calculated on the basis of the device-specific parameters (VS, T) and/or parameter combinations determined.

3. Method in accordance with Claim 2, **characterized in that** the input signal (DAM,' DFM) is calculated in each case in a digital section (15, 30) of the send circuit and an transferred to an amplifier circuit with a send amplifier (1) featuring a distorting analogue section of the send circuit, and the send signal (RFM) and the parameter (VS,T) are digitized using the receiver device and processed in the digital section, and that in the digital section 30) on the basis of the values of the parameters (VS, T) actually determined in each case and/or of the parameter combinations the corresponding pre-distorted signal (DAM, DFM) is calculated and fed to the analogue section.

4. Method in accordance with Claim 2 or 3, **characterized in that** an angle-modulated signal component (RF) and an amplitude modulation signal (AM) are created and merged in a send amplifier (1) of the amplifier circuit.

5. Method in accordance with one of the Claims 2 to 4, **characterized in that** from the parameters (VS, T) and/or parameter combinations determined and the dependent distortions of the send signal determined, characteristic curves are determined and a necessary pre-distortion is determined using the characteristic curves.

6. Method in accordance with one of the Claims 2 to 5, **characterized in that** a transmission function is determined and a necessary pre-distortion is determined using this transmission function.

7. Method in accordance with Claims 5 or 6, **characterized in that** the characteristic curves and/or the transmission function determined are stored..

8. Method in accordance with one of the Claims 5 to 7, **characterized in that** the characteristic curves and/or the transmission function are determined by a section of the send circuit which generates the input signal itself.

9. Method in accordance with Claim 8, **characterized in that** the determination of the characteristic curves and/or the transmission function occurs within a compensation mode.

10. Method in accordance with Claim 8 or 9, **characterized in that** the characteristic curves and/or transmission function are transferred during normal send operation.

11. Method in accordance with one of the Claims 8 to 10, **characterized in that** for the transfer of the characteristic curves and/or the transmission function at least one part (RS) of the send signal (RFM) is fed back to the part of the send circuit which generates the input signal.

12. Method in accordance with Claim 4, **characterized in that** the amplitude modulation signal (AM) is set by means of an amplifier which is operated depending on the output power in different operating modes, in which case a first operating mode includes a switching amplifier and a second operating mode includes continuous amplification, or which features transistors of different sizes, which are active or inactive in different combinations depending on the operating mode, or that the amplitude modulation signal (AM) is adjusted by means of an amplifier unit (62) which comprises a combination of a switching amplifier (63) and a continuous, broadband amplification (64) and/or controller.

13. Method in accordance with Claim 12, **characterized in that** the amplitude modulation signal (AM) is processed divided into a low-frequency component and a higher-frequency component.

14. Method in accordance with Claim 13, **characterized in that** the switching amplifier (35, 43, 63) is switched off or bridged for the low-frequency component of the amplitude modulation signal (AM) if only a low overall power of the amplitude modulations signal (AM) is required.

15. Method in accordance with one of the Claims 4 to 14, **characterized in that** the amplitude modulation signal (AM) is amplified using a combination of switching amplification and feed-forward procedure.

16. Method in accordance with one of the Claims 4 to 15, **characterized in that** the amplitude modulation signal (AM) is generated using a pulse-modulated signal (PM) from a supply voltage where the pulse-modulated signal (PM) is generated from a digital signal,

17. Method in accordance with Claim 16, **characterized in that** the pulse-modulated Signal (PM) comprises a pulse width and/or pulse frequency modulated signal (PM) which is generated from the digital signal using a timer circuit (44 to 50).

18. Method in accordance with Claim 17, **characterized in that** the pulse frequency modulated signal is generated by means of a digital synthesis circuit activated by a digital signal.

19. Method in accordance with Claim 17, **characterized in that** the pulse width modulated signal (PM) is generated using a clocked frequency divider (44 to 50) activated by a digital signal.

20. Method in accordance with Claim 19, **characterized in that** the output signals of a number of frequency dividers (44 to 50) are logically linked to each other to form a pulse width modulated signal.

21. Communication terminal which is designed not to send and receive signals at the same time, in which case the communication terminal has the following features:
a send circuit for generating a modulated send signal (RFM), where the send circuit includes means (15) for generating at least one input signal (DAM, DFM) which is fed to an amplifier circuit, in which case the input signal (DAM, DFM) is amplified by the amplifier circuit in order to generate the send signal,
a receiver device which at times at which the send signal is generated receives a part of the own send signal in order to analyze the send signal as regards distortion which are caused by the amplifier circuit,
means for coupling in at least a part of the send signal (RFM) into the receiver device for analysis of the send signal
**characterized in that** the receiver device includes means for conversion of the component of the send signal (RFM) received by the receiver device for analysis into the baseband in order to calculate there the distortions of the send signal (RFM) occurring there as a result of the amplifier circuit,
where the send circuit further includes means for pre-distortion of the relevant input signal (DAM, DFM) depending on the calculated distortions of the send signal and for feeding the pre-distorted input signal (DAM, DFM) to the amplifier circuit.

22. Communication terminal in accordance with Claim 21, **characterized by** means for recording device-specific parameters (VS, T) and/or parameter combinations, on the basis of which the pre-distortion is further calculated.

23. Communication terminal in accordance with Claim 22, **characterized by** means for measuring distortions occurring in the send signal (RFM) because of the amplifier circuit, means for determining the dependence of the distortions on a required signal and the parameters (VS, T) or parameter combinations.

24. Communication terminal in accordance with Claim 22, **characterized by** an analogue section which features the amplifier circuit with a send amplifier (1),
a digital section (15, 30) which calculates the input signal (DAM, DFM) and processes the send signal (RFM) and/or the electrical variables which describe its error and/or the parameters (VS,T) in digitized form, and which in each case on the basis of the required signal to be sent out and/or current determined values of the parameters (VS, T) and/or the parameter combinations transfers the input signal (DAM, DFM) correspondingly pre-distorted to the analogue section.

25. Communication terminal in accordance with one of the Claims 22 to 24, **characterized by** means for generating an angle-modulated signal component (RF), means for generating an amplitude modulation signal (AM) and means for merging the angle-modulated signal component (RF) and the amplitude modulation signal (AM) in a send amplifier (1) of the amplifier circuit.

26. Communication terminal in accordance with one of the Claims 22 to 25, **characterized by** means for determining characteristic curves and/or transmission functions.

27. Communication terminal in accordance with one of the Claims 22 to 26, **characterized by** a memory for storing the pre-distortions required for specific parameters and/or parameter combinations and/or the characteristic curves and/or the transmission functions.

28. Communication terminal in accordance with one of the Claims 22 to 27, **characterized by** direction-selective means (12) between an output of the send amplifier (1) and an antenna.

29. Communication terminal in accordance with Claim 25, **characterized by** means for separate processing of a low-frequency component and of a higher-frequency component of the amplitude modulation signal (AM).

30. Communication terminal in accordance with one of the Claims 22 to 29, **characterized by** a switching amplifier which features various operating modes, in which case a first operating mode comprises a switching amplifier and a second operating mode comprises continuous amplification or which features transistors of different sizes, which, depending on the operating mode, are active or inactive in different combinations, or an amplifier unit (62) which comprises a combination of a switching amplifier (63) and of a continuous broadband amplifier (64) and/or a controller.

31. Communication terminal in accordance with one of the Claims 22 to 30, **characterized by** switching means (69, 70, 72) for bridging and/or switching off components (63, 65) and/or combinations of components within regulation or control paths.

32. Communication terminal in accordance with Claim 25, **characterized by** a feed-forward path (41) with a divider (38) for executing a feed-forward correction for amplification of the amplitude modulation signal (AM).

33. Communication terminal in accordance with one of the Claims 22 to 32, **characterized by** a pulse modulator (43) for creation of a pulse-modulated signal (PM) from a digital signal as well as a downstream filter (24) for generation of an analogue amplitude modulation signal (AM).

34. Communication terminal in accordance with Claim 33, **characterized in that** the pulse modulator (PM) includes a counter circuit (44 to 50) for generating a pulse width or pulse frequency modulated signal (PM).

35. Communication terminal in accordance with Claim 34, **characterized in that** the pulse modulator includes a digital synthesis circuit for generating a pulse frequency modulated signal.

36. Communication terminal in accordance with Claim 34, **characterized in that** the pulse modulator (43) includes a clocked frequency divider (44 to 50) activated by a digital signal for generation of a pulse width modulated signal (PM).

37. Communication terminal in accordance with Claim 36, **characterized in that** the pulse modulator (43) includes a number of frequency dividers (44 to 50) connected to each other by means of logic gates (51, 52).

38. Communication terminal in accordance with one of the Claims 22 to 37, **characterized by** A/D converters (16, 22, 33) in feed-forward branches for which current values of the amplitude and/or of the angle of the send signal and/or of a signal derived from it and means for executing a digital comparison of actual and required values for the amplitude and/or of the angle and/or of derived variables.

## Revendications

1. Procédé pour produire un signal d'émission modulé (RFM) dans un terminal de communication, lequel est conçu de manière à ne pas émettre et recevoir simultanément des signaux, le terminal de communication comportant un dispositif de réception et un circuit d'émission,
au moins un signal d'entrée (DAM, DFM) étant amené à un circuit amplificateur, dans le circuit d'émission, ledit signal subissant une amplification dans le circuit amplificateur pour produire le signal d'émission,
des distorsions qui surviennent dans le signal d'émission (RFM) à cause du circuit amplificateur ainsi que la dépendance des distorsions par rapport à un signal de consigne se voyant déterminées,
une partie prédéterminée du signal d'émission étant amenée, dans les temps dans lesquels le signal d'émission est produit, au dispositif de réception pour y être analysée,
**caractérisé en ce que** la fraction du signal d'émission destinée à être analysée est convertie vers la bande de base, dans le dispositif de réception, pour y calculer les distorsions du signal d'émission (RFM) survenant à cause du circuit amplificateur, en fonction desquelles l'au moins un signal d'entrée (DAM, DFM) est pré-distordu et amené au circuit amplificateur.

2. Procédé selon la revendication 1, **caractérisé en ce que** la prédistorsion est par ailleurs calculée sur la base de paramètres (VS, T) et/ou de combinaisons de paramètres déterminés spécifiques à l'appareil.

3. Procédé selon la revendication 2, **caractérisé en ce que** le signal d'entrée (DAM, DFM) est respectivement calculé dans une partie numérique (15, 30) du circuit d'émission et est transmis à une partie analogique du circuit d'émission, laquelle distord et comporte le circuit amplificateur avec un amplificateur d'émission (1), et le signal d'émission (RFM) et les paramètres (VS, T) sont numérisés moyennant l'utilisation du dispositif de réception et sont traités dans la partie numérique et **en ce que** le signal (DAM, DFM) pré-distordu de manière correspondante est calculé dans la partie numérique (15, 30) respectivement à l'aide des valeurs actuellement déterminées des paramètres (VS, T) et/ou des combinaisons de paramètres et est amené à la partie analogique.

4. Procédé selon la revendication 2 ou 3, **caractérisé en ce qu'**une fraction de signal modulée angulairement (RF) et un signal de modulation d'amplitude (AM) sont produits et regroupés dans un amplificateur d'émission (1) du circuit amplificateur.

5. Procédé selon l'une des revendications 2 à 4, **caractérisé en ce que** des lignes caractéristiques sont déterminées au départ des paramètres (VS, T) et/ou des combinaisons de paramètres déterminés et des distorsions du signal d'émission déterminées qui en dépendent et **en ce qu'**une prédistorsion nécessaire est déterminée moyennant l'utilisation de ces lignes caractéristiques.

6. Procédé selon l'une des revendications 2 à 5, **caractérisé en ce qu'**une fonction de transfert est déterminée et une prédistorsion nécessaire est déterminée moyennant l'utilisation de cette fonction de transfert.

7. Procédé selon la revendication 5 ou 6, **caractérisé en ce que** les lignes caractéristiques déterminées et/ou la fonction de transfert sont enregistrées.

8. Procédé selon l'une des revendications 5 à 7, **caractérisé en ce que** les lignes caractéristiques et/ou la fonction de transfert sont déterminées par une partie de circuit du circuit d'émission elle-même, laquelle produit le signal d'entrée.

9. Procédé selon la revendication 8, **caractérisé en ce que** la détermination des lignes caractéristiques et/ou de la fonction de transfert se fait à l'intérieur d'un mode d'ajustage.

10. Procédé selon la revendication 8 ou 9, **caractérisé en ce que** la détermination des lignes caractéristiques et/ou de la fonction de transfert se fait pendant le mode d'émission normal.

11. Procédé selon l'une des revendications 8 à 10, **caractérisé en ce que**, pour la détermination des lignes caractéristiques et/ou de la fonction de transfert, au moins une partie (RS) du signal d'émission (RFM) est rétrocouplée sur la partie de circuit du circuit d'émission qui produit le signal d'entrée.

12. Procédé selon la revendication 4, **caractérisé en ce que** le signal de modulation d'amplitude (AM) est ajusté au moyen d'un amplificateur qui est opéré dans différents modes opératoires en fonction de la puissance de sortie, un premier mode opératoire comprenant un amplificateur à commutation et un deuxième mode opératoire comprenant une amplification en continu, ou qui comporte des transistors de différentes tailles qui sont actifs ou inactifs dans des combinaisons différentes selon le mode opératoire ou **en ce que** le signal de modulation d'amplitude (AM) est ajusté au moyen d'une unité d'amplification (62) qui comprend une combinaison d'un amplificateur à commutation (63) et d'un amplificateur continu à large bande (64) et/ou d'un régulateur.

13. Procédé selon la revendication 12, **caractérisé en ce que** le signal de modulation d'amplitude (AM) est traité après avoir été partagé en une fraction basses fréquences et une fraction de fréquences supérieures.

14. Procédé selon la revendication 13, **caractérisé en ce que** l'amplificateur à commutation (35, 43, 63) est coupé et/ou ponté pour la fraction basses fréquences du signal de modulation d'amplitude (AM) pour une puissance globale requise uniquement faible du signal de modulation d'amplitude (AM).

15. Procédé selon l'une des revendications 4 à 14, **caractérisé en ce que** le signal de modulation d'amplitude (AM) est amplifié moyennant l'utilisation d'une combinaison de l'amplification à commutation et d'un procédé «Feed Forward».

16. Procédé selon l'une des revendications 4 à 15, **caractérisé en ce que** le signal de modulation d'amplitude (AM) est produit moyennant l'utilisation d'un signal modulé en impulsions (PM) au départ d'une tension d'alimentation, le signal modulé en impulsions (PM) étant produit au départ d'un signal numérique.

17. Procédé selon la revendication 16, **caractérisé en ce que** le signal modulé en impulsions (PM) comprend un signal modulé en largeur d'impulsions et/ou en fréquence d'impulsions (PM), lequel est produit au départ du signal numérique moyennant l'utilisation d'un circuit compteur (44 à 50).

18. Procédé selon la revendication 17, **caractérisé en ce que** le signal modulé en fréquence d'impulsions est produit au moyen d'un circuit de synthèse numérique commandé par un signal numérique.

19. Procédé selon la revendication 17, **caractérisé en ce que** le signal modulé en largeur d'impulsions (PM) est produit moyennant l'utilisation d'un diviseur de fréquence (44 à 50) rythmé et commandé par un signal numérique.

20. Procédé selon la revendication 19, **caractérisé en ce que** les signaux de sortie de plusieurs diviseurs de fréquence (44 à 50) sont associés logiquement entre eux pour former un signal modulé en largeur d'impulsions.

21. Terminal de communication conçu pour ne pas émettre et recevoir simultanément des signaux, le terminal de communication présentant les caractéristiques suivantes:
un circuit d'émission pour produire un signal d'émission modulé (RFM), le circuit d'émission comprenant des moyens (15) pour produire au moins un signal d'entrée (DAM, DFM) qui est amené à un circuit amplificateur, le signal d'entrée (DAM, DFM) étant amplifié par le circuit amplificateur pour produire le signal d'émission;
un dispositif de réception qui, pendant les temps pendant lesquels le signal d'émission est en cours de production, reçoit une partie du propre signal d'émission pour analyser le signal d'émission pour ce qui est de distorsions causées par le circuit amplificateur;
des moyens pour injecter au moins une partie du signal d'émission (RFM) dans le dispositif de réception pour l'analyse du signal d'émission,
**caractérisé en ce que** le dispositif de réception comprend des moyens pour convertir vers la bande de base la fraction du signal d'émission (RFM) reçue par le dispositif de réception et destinée à l'analyse, pour y calculer les distorsions du signal d'émission (RFM) qui surviennent à cause du circuit amplificateur,
le circuit d'émission comprenant en outre des moyens pour la prédistorsion du signal d'entrée (DAM, DFM) respectif en fonction des distorsions calculées du signal d'émission et pour amener le signal d'entrée (DAM, DFM) pré-distordu au circuit amplificateur.

22. Terminal de communication selon la revendication 21, **caractérisé par** des moyens pour la détection de paramètres (VS, T) et/ou de combinaisons de paramètres spécifiques à l'appareil, sur la base desquels est en outre calculée la prédistorsion.

23. Terminal de communication selon la revendication 22, **caractérisé par** des moyens de mesure de distorsions survenant dans le signal d'émission (RFM) à cause du circuit amplificateur,
des moyens pour la détermination de la dépendance des distorsions par rapport à un signal de consigne et aux paramètres (VS, T) resp. aux combinaisons de paramètres.

24. Terminal de communication selon la revendication 22, **caractérisé par** une partie analogique qui comporte le circuit amplificateur avec un amplificateur d'émission (1),
une partie numérique (15, 30) qui calcule le signal d'entrée (DAM, DFM) et traite le signal d'émission (RFM) et/ou des grandeurs électriques décrivant son erreur et/ou les paramètres (VS, T) sous une forme numérisée et qui remet à la partie analogique le signal d'entrée (DAM, DFM), pré-distordu en conséquence, respectivement à l'aide du signal de consigne à émettre et/ou de valeurs actuellement déterminées des paramètres (VS, T) et/ou des combinaisons de paramètres.

25. Terminal de communication selon l'une des revendications 22 à 24, **caractérisé par** des moyens pour produire une fraction de signal modulée angulairement (RF), des moyens pour produire un signal de modulation d'amplitude (AM) et des moyens pour regrouper la fraction de signal modulé angulairement (RF) et le signal de modulation d'amplitude (AM) dans un amplificateur d'émission (1) du circuit amplificateur.

26. Terminal de communication selon l'une des revendications 22 à 25, **caractérisé par** des moyens pour déterminer des lignes caractéristiques et/ou des fonctions de transfert.

27. Terminal de communication selon l'une des revendications 22 à 26, **caractérisé par** une mémoire pour enregistrer les prédistorsions, requises dans le cas de certains paramètres et/ou de certaines combinaisons de paramètres, et/ou les lignes caractéristiques et/ou les fonctions de transfert.

28. Terminal de communication selon l'une des revendications 22 à 27, **caractérisé par** des moyens sélectifs de direction (12) entre une sortie de l'amplificateur d'émission (1) et une antenne.

29. Terminal de communication selon la revendication 25, **caractérisé par** des moyens pour le traitement séparé d'une fraction basses fréquences et d'une fraction de fréquences supérieures du signal de modulation d'amplitude (AM).

30. Terminal de communication selon l'une des revendications 22 à 29, **caractérisé par** un amplificateur à commutation comportant différents modes opératoires, un premier mode opératoire comprenant une amplification à commutation et un deuxième mode opératoire comprenant une amplification en continu, ou qui comporte des transistors de différentes tailles qui sont actifs ou inactifs dans des combinaisons différentes selon le mode opératoire, ou une unité d'amplification (62) qui comprend une combinaison d'un amplificateur à commutation (63) et d'un amplificateur continu à large bande (64) et/ou d'un régulateur.

31. Terminal de communication selon l'une des revendications 22 à 30, **caractérisé par** des moyens de commutation (69, 70, 72) pour ponter et/ou couper des composants (63, 65) et/ou des combinaisons de composants à l'intérieur de voies d'asservissement ou de commande.

32. Terminal de communication selon la revendication 25, **caractérisé par** un chemin de rétrocouplage (41) avec un diviseur (38) pour l'exécution d'une correction «Feed Forward» dans le cas d'une amplification du signal de modulation d'amplitude (AM).

33. Terminal de communication selon l'une des revendications 22 à 32, **caractérisé par** un modulateur d'impulsions (43) pour produire un signal modulé en impulsions (PM) au départ d'un signal numérique ainsi que par un filtre (24) monté en aval, pour produire un signal analogique de modulation d'amplitude (AM).

34. Terminal de communication selon la revendication 33, **caractérisé en ce que** le modulateur d'impulsions (PM) comprend un circuit compteur (44 à 50) pour produire un signal (PM) modulé en largeur d'impulsions ou en fréquence d'impulsions.

35. Terminal de communication selon la revendication 34, **caractérisé en ce que** le modulateur d'impulsions comprend un circuit de synthèse numérique pour produire un signal modulé en fréquence d'impulsions.

36. Terminal de communication selon la revendication 34, **caractérisé en ce que** le modulateur d'impulsions (43) comprend un diviseur de fréquence (44 à 50), rythmé et commandé par un signal numérique, pour produire un signal (PM) modulé en largeur d'impulsions.

37. Terminal de communication selon la revendication 36, **caractérisé en ce que** le modulateur d'impulsions (43) comprend plusieurs diviseurs de fréquence (44 à 50) qui sont reliés entre eux au moyen de portes logiques (51, 52).

38. Terminal de communication selon l'une des revendications 22 à 37, **caractérisé par** des convertisseurs analogique - numérique (16, 22, 33) dans des branches de rétrocouplage pour les valeurs actuelles de l'amplitude et/ou de l'angle du signal d'émission et/ou d'un signal qui en est dérivé et des moyens pour effectuer une comparaison numérique entre des valeurs effectives et de consigne pour l'amplitude et/ou l'angle et/ou une grandeur qui en est dérivée.
